(19) Europäisches Patentamt
European Patent Office
Office européen des brevets

(11) EP 1 146 087 B1

(12) # EUROPÄISCHE PATENTSCHRIFT

(45) Veröffentlichungstag und Bekanntmachung des Hinweises auf die Patenterteilung:
**05.11.2003 Patentblatt 2003/45**

(51) Int Cl.[7]: **C09B 45/14**, G02B 5/20, G03F 7/004, C09D 11/00

(21) Anmeldenummer: **01106443.3**

(22) Anmeldetag: **23.03.2001**

(54) **Organische Pigmente für Farbfilter in LCD**

Organic pigments for LCD colour filter

Pigments organiques pour filtres colorés pour afficheurs à cristaux liquides

(84) Benannte Vertragsstaaten:
**AT BE CH CY DE DK ES FI FR GB GR IE IT LI LU MC NL PT SE TR**

(30) Priorität: **04.04.2000 DE 10016665**
**22.05.2000 DE 10025303**

(43) Veröffentlichungstag der Anmeldung:
**17.10.2001 Patentblatt 2001/42**

(73) Patentinhaber: **BAYER AG**
**51368 Leverkusen (DE)**

(72) Erfinder:
- **Wolf, Mickey**
**51375 Leverkusen (DE)**
- **Richter, Rolf, Dr.**
**51373 Leverkusen (DE)**
- **Faubion, Kent**
**Charleston, SC 29401 (US)**
- **Herrmann, Udo, Dr.**
**41541 Dormagen (DE)**
- **Witt, Josef**
**51377 Leverkusen (DE)**
- **Nyssen, Peter-Roger**
**41542 Dormagen (DE)**

(56) Entgegenhaltungen:
**EP-A- 0 073 463**
**EP-A- 0 839 879**
**EP-A- 0 947 563**
**EP-A- 0 994 164**
**EP-A- 1 086 992**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

EP 1 146 087 B1

Printed by Jouve, 75001 PARIS (FR)

## Beschreibung

Die Erfindung betrifft die Verwendung von Metallkomplexpigmenten in Farbfiltern sowie Pigmentpräparationen und ihre Verwendung zur Herstellung von Farbfiltern sowie die Farbfilter selbst.

Farbfilter finden heute vornehmlich Anwendung in Flüssigkristallanzeigen, -bildschirmen, Farbauflösungsgeräten und Sensoren. Ein bekanntes Beispiel sind die Flachbildschirme bei Personalkomputem. Es gibt verschiedene Methoden zur Herstellung der Farbfilter, die sich sowohl in der Auftragung der Farben als auch der Erzeugung der Farbelementmuster der Basisfarben rot, grün und blau neben schwarz unterscheiden. Die Applikation bzw. Auftragung der Farben kann z.B. durch Einfärben einer Trägerschicht (z.B. Gelatine) mittels löslichen Farbstoffen oder Pigmenten ("Dye Method", "Dye Dispersion Method"), Siebdruck , Offsetdruck oder Tintenstrahldruck von Pigmentpasten, -präparationen oder -tinten, Elektrodeposition von Photolacken auf Basis von Farbstoffen oder Pigmenten sowie insbesondere mittels der Pigment-Dispersionsmethode, bei der Pigmente verwendet werden, die entweder in einem Polyimidharz ("nicht-photosensitive Polyimidmethode") oder in einem Photolack ("photosensitive Acrylmethode") dispergiert sind, erfolgen. Verbunden mit den genannten Verfahren kommt sowohl der drucktechnisch direkten Erzeugung der Farbelementmuster als auch der indirekten, photolithographischen Erzeugung Bedeutung zu, letztere insbesondere bei der o.g. Pigmentdispersionsmethode. Die Technik der Pigment-Dispersionsmethode in Form der "nicht-photosensitiven Polyimidmethode" ist beispielsweise in JP-A-11-217514 (1998) offenbart.

Bei der Pigment-Dispersionsmethode nach dem Photolackverfahren liegen die farbgebenden Pigmente in einem UV-härtbaren Photolack feinverteilt (dispergiert) vor. Der Photolack besteht dabei neben dem Pigment im Allgemeinen aus den Komponenten Bindemittelharz, polymerisierbares Monomer, Photoinitiator sowie gegebenenfalls einem Lösungsmittel. Die Herstellung erfolgt z.B. derart, dass zunächst das Pigment in Form eines Konzentrates Lösungsmittel und gegebenenfalls Bindemittelharz feinteilig dispergiert wird und unmittelbar vor der Applikation zusammen mit dem Monomer und dem Photoinitiator sowie ggf. weiteren Komponenten eingestellt wird. Der pigmentierte Fotolack wird auf das Substrat, z.B. Glass, gleichmäßig aufgetragen, z.B. mittels dem sogenannten "spin coating"-Verfahren, vorgetrocknet, mittels einer Fotomaske UV belichtet, mittels einer in der Regel anorganisch alkalischen Lösung zu den gewünschten Farbelementmustern entwickelt, die Beschichtung gereinigt und gegebenenfalls nachgehärtet. Dieser Prozess wird für jede Farbe wiederholt, in der Regel also 3 mal für eine Trichromie z.B. in den Farben rot, grün und blau.

Die Vorteile bei der Verwendung von Pigmenten in Verbindung mit der Pigment-Dispersionsmethode liegen in der verbesserten Licht-, Feuchtigkeits- und Temperaturbeständigkeit der Farbfilter im Vergleich zu farbstoff-basierenden Beschichtungssystemen. Demgegenüber sind die Transparenz und Farbreinheit der Beschichtungen auf Basis von Pigmenten, unabhängig vom Beschichtungsverfahren, noch nicht zufriedenstellend. Insbesondere wenn verschiedene Pigmente in Mischung zur Nuancierung auf die gewünschten Farbortwerte im Fotolack eingearbeitet werden, kommt es zu unerwünschten Brillianz- und Transparenzverlusten, so dass als Folge die Anzeigen bzw. Bildschirme (LCD) mit einem erhöhten Energieaufwand betrieben werden müssen.

Aus EP-A-947563 sind spezielle Azopyrazolone für den Einsatz in Farbfiltern beschrieben.

Einzelne Pigmente, die nach dem Stand der Technik in Farbfiltern zum Einsatz kommen, sind z.B. in JP-A-11-217514, JP-A-11-209631: spezielles Pigment Color Index Pigment Yellow 150 und JP-A-11-209632 offenbart. Diese sind jedoch im Hinblick auf die beschriebenen Anforderungen noch zu verbessern.

Aufgabe der vorliegenden Erfindung ist daher die Bereitstellung von neuen Pigmenten für die Verwendung in Farbfiltern mit verbesserter Farbreinheit und Transparenz und besserer Lichtechtheit.

Ferner sollen die Pigmente leicht in polaren und unpolaren organischen Medien dispergierbar sein, so dass sie in den verschiedenen Matrixsystemen bzw. Trägermedien der genannten Herstellungsmethoden für Farbfilter feinteilig zu stabilisieren sind.

Überraschenderweise wurde gefunden, dass spezielle Metallkomplexpigmente wie sie in ähnlicher Weise in EP-A-73463 beschrieben sind, die geforderten Echtheitsund koloristischen Anforderungen, insbesondere Transparenz und Farbreinheit in Mischungen untereinander und mit anderen Pigmenten sehr gut erfüllen.

Die Erfindung betrifft daher die Verwendung von Metallkomplexpigmenten einer Azo-Verbindung, die der Formel (I) oder einer ihrer tautomeren Strukturen entspricht

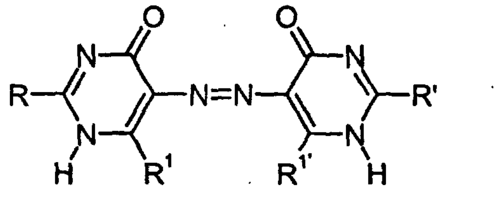

(I),

in der

R und R' unabhängig voneinander für OH, $NH_2$, NH-CN, Arylamino oder Acylamino stehen und

$R^1$ und $R^{1'}$ unabhängig voneinander -OH oder $-NH_2$ bedeuten,

und die wenigstens eine Verbindung eingelagert enthalten, wobei die Metallkomplexe den Mono, Di-, Tri- und Tetraanionen der Azo-Verbindungen der Formel (I) mit den Metallen Li, Cs, Mg, Cd, Co, Al, Cr, Sn, Pb, besonders bevorzugt Na, K, Ca, Sr, Ba, Zn, Fe, Ni, Cu, Mn und La entsprechen, in Farbfiltern für Flüssigkristallanzeigen.

Substituenten in der Bedeutung von Aryl in Formel (I) bedeuten vorzugsweise Phenyl oder Naphthyl, die gegebenenfalls substituiert sind, beispielsweise durch Halogen wie F, Cl, Br, -OH, $C_1$-$C_6$-Alkyl, $C_1$-$C_6$-Alkoxy, $-NH_2$, $-NO_2$ und -CN.

Substituenten in der Bedeutung von Acyl in Formel (I) bedeuten vorzugsweise ($C_1$-$C_6$-Alkyl)-carbonyl, Phenylcarbonyl, $C_1$-$C_6$-Alkylsulfonyl, Phenylsulfonyl, gegebenenfalls durch $C_1$-$C_6$-Alkyl, Phenyl oder Naphthyl substituiertes Carbamoyl, gegebenenfalls durch $C_1$-$C_6$-Alkyl, Phenyl oder Naphthyl substituiertes Sulfamoyl oder gegebenenfalls durch $C_1$-$C_6$-Alkyl, Phenyl oder Naphthyl substituiertes Guanyl, wobei die genannten Alkylreste beispielsweise durch Halogen insbesondere Cl, Br oder F, -OH, -CN, $-NH_2$ und/oder $C_1$-$C_6$-Alkoxy substituiert sein können und die genannten Phenyl- und Naphthylreste beispielsweise durch Halogen insbesondere F, Cl oder Br, -OH, $C_1$-$C_6$-Alkyl, $C_1$-$C_6$-Alkoxy, $-NH_2$, $-NO_2$ und/oder -CN substituiert sein können.

Gegenstand der Erfindung ist insbesondere die Verwendung von Metallkomplexpigmenten, die auf Basis der Mono- und/oder Dikaliumsalze einer Azo-Verbindung die der Formel (I) oder einer ihrer tautomeren Formeln hergestellt worden sind, sowie ihrer Hydrate als Pigmente in Farbfiltern für Flüssigkristall anzeigen.

Diese den erfindungsgemäß zu verwendenden Metallkomplexen zugrundeliegenden Salze enthalten vorzugsweise keine oder nur vernachlässigbare Mengen an Diazobarbitursäure, die Metallkomplexe selber sind daher besonders arm an Nebenprodukten und daher im Hinblick auf Farbreinheit und Transparenz für die Verwendung in Farbfilter ganz besonders geeignet.

Unter Metallkomplexen werden im Rahmen dieser Anmeldung auch Metallsalze verstanden.

Ganz besonders bevorzugte Metallkomplexe sind dabei solche von Azo-Verbindungen der Formel (I), vorzugsweise von den Kaliumsalzen dieser Azo-Verbindungen, die in form ihrer freien Säure oder einer ihrer tautomeren Strukturen der Formel (II) entsprechen

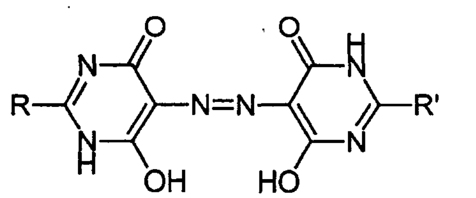

(II),

in der

R und R' unabhängig voneinander OH und NHCN bedeuten,

und die wenigstens eine andere Vrebindung eingelagert enthalten.

Bevorzugt vor allem sind dabei organische Metallkomplexe solcher Azo- Verbindungen der Formel (II), vorzugsweise von den Kaliumsalzen dieser Azo- Verbindungen, die in Form ihrer freien Säure oder einer der tautomeren Strukturen der Formeln (IIa bis IIc) entsprechen

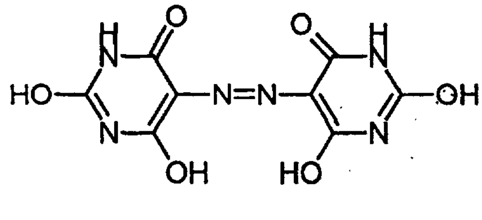

(IIa),

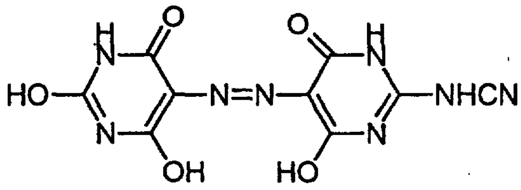

(IIb),

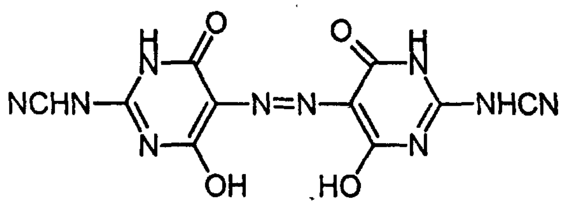

(IIc).

Besonders bevorzugt sind dabei organische Metallkomplexe des Mono- oder Dikaliumsalzes der Azobarbitursäure der Formel (I), insbesondere (IIa).

Besonders bevorzugt handelt es sich bei den Verbindungen der Formel (I) um die 1:1 Azo-Metall-Komplexe, die der Formel (Ia) oder einer ihrer tautomeren Formen entsprechen

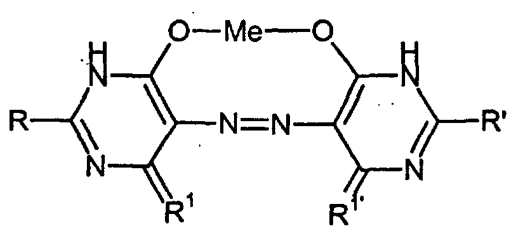

(Ia),

worin

| | |
|---|---|
| Me | eines der obengenannten Metallzentren entspricht, |
| R und R' | die oben angegebenen Bedeutungen besitzen und |
| $R^1$ und $R^{1'}$ | unabhängig voneinander = O oder =NH bedeuten. |

Besonders bevorzugt sind Salze und Komplexe der Formeln (I, Ia, IIa, IIb, IIc) mit zwei- oder dreiwertigen Metallen, ganz besonders die Nickelsalze und -komplexe.

Ganz besonders bevorzugt verwendet werden Metallkomplexe, bei denen der Azobarbitursäure-Nickel-1:1-Komplex einer der tautomeren Formen der Formel (IIa) entspricht und mindestens eine andere Verbindung eingelagert enthält.

Im allgemeinen bildet die Metallkomplexverbindung ein schichtförmiges Kristallgitter, bei dem die Bindung innerhalb einer Schicht im wesentlichen über Wasserstoffbrücken und/oder Metallionen erfolgt. Vorzugsweise handelt es sich dabei um Metallverbindungen, die ein Kristallgitter ausbilden, das aus im wesentlichen ebenen Schichten besteht.

Die Metallkomplexe mit eingelagerten anderen Verbindungen können als Einschlussverbindungen, Interkalationsverbindungen sowie als feste Lösungen vorliegen.

Als Metallkomplexe kommen auch solche in Frage, bei denen eine metallhaltige Verbindung, z.B. ein Salz oder Metallkomplex in das Kristallgitter des Metallkomplexes eingebaut ist. In diesem Fall kann ein Teil des Metalls der Metallsalze der Azoverbindung der Formel (I) durch andere Metallionen ersetzt sein oder es können weitere Metallionen in eine mehr oder weniger starke Wechselwirkung mit dem Metallkomplex treten.

Eingelagert sein können sowohl organische als auch anorganische Verbindungen.

Verbindungen, die eingelagert sein können, entstammen den verschiedenartigsten Verbindungsklassen. Aus rein praktischen Gründen sind solche Verbindungen bevorzugt, die unter Normalbedingungen (25°C, 1 bar) flüssig oder fest sind.

Von den flüssigen Substanzen sind wiederum solche bevorzugt, die einen Siedepunkt (1 bar) von 100°C oder darüber, bevorzugt von 150°C und darüber, aufweisen. Geeignete Verbindungen sind vorzugsweise acyclische und cyclische organische Verbindungen, z.B. aliphatische und aromatische Kohlenwasserstoffe, die substituiert sein können, z.B. durch OH, COOH, $NH_2$, substituiertes $NH_2$, $CONH_2$, substituiertes $CONH_2$, $SO_2NH_2$, substituiertes $SO_2NH_2$, $SO_3H$, Halogen, $NO_2$, CN, -$SO_2$-Alkyl, -$SO_2$-Aryl, -O-Alkyl, -O-Aryl und/oder -O-Acyl.

Substituenten in der Bedeutung von Aryl bedeuten vorzugsweise Phenyl oder Naphthyl, die gegebenenfalls substituiert sind beispielsweise durch Halogen wie F, Cl, Br, -OH, $C_1$-$C_6$-Alkyl, $C_1$-$C_6$-Alkoxy, -$NH_2$, -$NO_2$ und/oder -CN.

Substituenten in der Bedeutung von Alkyl bedeuten vorzugsweise $C_1$-$C_6$-Alkyl, das gegebenenfalls substituiert ist, beispielsweise durch Halogen, wie Chlor, Brom, Fluor, -OH, -CN, -$NH_2$ und/oder $C_1$-$C_6$-Alkoxy.

Substituenten in der Bedeutung von Cycloalkyl bedeuten vorzugsweise $C_3$-$C_7$-Cycloalkyl, insbesondere $C_5$-$C_6$-Cycloalkyl, das gegebenenfalls substituiert ist, beispielsweise durch $C_1$-$C_6$-Alkyl, $C_1$-$C_6$-Alkoxy, Halogen wie Cl, Br, F, $C_1$-$C_6$-Alkoxy, -OH, -CN und/oder $NH_2$.

Substituenten in der Bedeutung von Aralkyl bedeuten bevorzugt Phenyl- oder Naphthyl-$C_1$-$C_4$-alkyl, die am aromatischen Rest gegebenenfalls substituiert sind, beispielsweise durch Halogen wie F, Cl, Br, -OH, $C_1$-$C_6$-Alkyl, $C_1$-$C_6$-Alkoxy, -$NH_2$, -$NO_2$ und/oder -CN.

Substituenten in der Bedeutung von Acyl bedeuten vorzugsweise ($C_1$-$C_6$-Alkyl)-carbonyl, Phenylcarbonyl, $C_1$-$C_6$-Alkylsulfonyl, Phenylsulfonyl, gegebenenfalls durch $C_1$-$C_6$-Alkyl, Phenyl oder Naphthyl substituiertes Carbamoyl, gegebenenfalls durch $C_1$-$C_6$-Alkyl, Phenyl oder Naphthyl substituiertes Sulfamoyl oder gegebenenfalls durch $C_1$-$C_6$-Alkyl, Phenyl oder Naphthyl substituiertes Guanyl, wobei die genannten Alkylreste gegebenenfalls substituiert sind, beispielsweise durch Halogen wie Cl, Br, F, -OH, -CN, -$NH_2$ und/oder $C_1$-$C_6$-Alkoxy und die genannten Phenylund Naphthylreste gegebenenfalls substituiert sind, beispielsweise durch Halogen wie F, Cl, Br, -OH, $C_1$-$C_6$-Alkyl, $C_1$-$C_6$-Alkoxy, -$NH_2$, -$NO_2$ und/oder -CN.

Im einzelnen seien als einzulagernde Verbindungen z.B. genannt: Paraffine und Paraffinöle; Triisobutylen, Tetraisobutylen, Mischungen von aliphatischen und aromatischen Kohlenwasserstoffen, wie sie z.B. bei der Erdölfraktionierung anfallen; chlorierte Paraffinkohlenwasserstoffe wie Dodecylchlorid oder Stearylchlorid; $C_{10}$-$C_{30}$-Alkohole wie 1-Decanol, 1-Dodecanol, 1-Hexadecanol, 1-Octadecanol und ihre Mischungen, Oleinalkohol, 1,12-Octadecandiol, Fettsäuren und ihre Salze und Mischungen, z.B. Ameisensäure, Essigsäure, Dodecansäure, Hexadecansäure, Octadecansäure, Ölsäure, Fettsäureester, z.B. die Methylester der $C_{10}$-$C_{20}$-Fettsäuren, Fettsäureamide, wie Stearinsäureamid, Stearinsäuremonoethanolamid, Stearinsäurediethanolamid, Stearinsäurenitril, Fettamine, z.B. Dodecylamin, Cetylamin, Hexadecylamin, Octadecylamin und andere; Salze von Fettaminen mit Sulfonund Carbonsäuren, isocyclische Kohlenwasserstoffe wie Cyclododecan, Decahydronaphthalin, o-, m-, p-Xylol, Mesitylen, Dodecylbenzolgemisch, Tetralin, Naphthalin, 1-Methylnaphthalin, 2-Methylnaphthalin, Biphenyl, Diphenylmethan, Acenaphthen, Fluoren, Anthracen, Phenanthren, m-, p-Terphenyl, o-, p-Dichlorbenzol, Nitrobenzol, 1-Chlornaphthalin, 2-Chlornaphthalin, 1-Nitronaphthalin, isocyclische Alkohole und Phenole und ihre Abkömmlinge wie Benzylalkohol, Decahydro-2-naphthol, Diphenylether, Sulfone, z.B. Diphenylsulfon, Methylphenylsulfon, 4,4'-Bis-2-(hydroxyethoxy)-diphenylsulfon; isocyclische Carbonsäuren und ihre Derivate wie Benzoesäure, 3-Nitrobenzoesäure, Zimtsäure, 1-Naphthalincarbonsäure, Phthalsäure, Phthalsäuredibutylester, Phthalsäuredioctylester, Tetrachlorphthalsäure, 2-Nitrobenzamid, 3-Nitrobenzamid, 4-Nitrobenzamid, 4-Chlorbenzamid, Sulfonsäuren, wie 2,5-Dichlorbenzolsulfonsäure, 3-Nitro-, 4-Nitrobenzolsulfonsäure, 2,4-Dimethylbenzolsulfonsäure, 1- und 2-Naphthalinsulfonsäure, 5-Nitro-1- und 5-Nitro-2-naphthalinsulfonsäure, Di-sec.-butyl-naphthalinsulfonsäuregemisch, Biphenyl-4-sulfonsäure, 1,4-, 1,5-, 2,6-, 2,7-Naphthalindisulfonsäure, 3-Nitro-1,5-naphthalindisulfonsäure, Anthrachinonsulfonsäure-1, Anthrachinonsulfonsäure-2, Diphenyl-4,4'-disulfonsäure, 1,3,6-Naphthalintrisulfonsäure und die Salze dieser Sulfonsäuren z.B. die Natrium-, Kalium-, Calcium-, Zink-, Nickel- und Kupfersalze; Sulfonamide wie Benzolsulfonamid, 2-, 3- und 4-Nitrobenzolsulfonamid, 2-, 3- und 4-Chlorbenzolsulfonamid, 4-Methoxy-benzolsulfonamid, 3,3'-Sulfonylbisbenzolsulfonamid, 4,4'-Oxybisbenzolsulfonsäureamid, 1- und 2-Naphthalinsulfonsäureamid.

Carbonsäure- und Sulfonsäureamide sind eine bevorzugte Gruppe von einzuschließenden Verbindungen, insbesondere geeignet sind auch Harnstoff und substituierte Harnstoffe wie Phenylharnstoff, Dodecylharnstoff und andere, sowie deren Polykondensate mit Aldehyden, insbesondere Formaldehyd; Heterocyclen wie Barbitursäure, Benzimidazolon, Benzimidazolon-5-sulfonsäure, 2,3-Dihydroxychinoxalin, 2,3-Dihydroxychinoxalin-6-sulfonsäure, Carbazol, Carbazol-3,6-disulfonsäure, 2-Hydroxychinolin, 2,4-Dihydroxychinolin, Caprolactam, Melamin, 6-Phenyl-1,3,5-triazin-2,4-diamin, 6-Methyl-1,3,5-triazin-2,4-diamin und Cyanursäure.

Bevorzugte Metallkomplexe enthalten eingeschlossen grenzflächenaktive Verbindungen, insbesondere Tenside, die z.B. aus K. Lindner, Tenside-Textilhilfsmittel-Waschrohstoffe, 2. Auflage, Band I, Wissenschaftliche Verlagsgesellschaft mbH, Stuttgart, 1964, bekannt sind. Dabei kann es sich um anionenaktive, nichtionogene oder kationenaktive Verbindungen oder um Ampholyte handeln. Geeignete anionenaktive Verbindungen sind z.B.: Echte Seifen, Salze der Aminocarbonsäuren, Salze niederer bzw. höherer acylierter Aminocarbonsäuren, Fettsäuresulfate, Sulfate von Fettsäureestern, -amiden usw., primäre Alkylsulfate, Sulfate von Oxoalkoholen, sekundäre Alkylsulfate, Sulfate veresterter oder veretherter Polyoxyverbindungen, Sulfate substituierter Polyglykolether (sulfatierte Ethylenoxidaddukte), Sulfate acylierter oder-alkylierter Alkanolamine, Sulfonate von Fettsäuren, ihren Estern, Amiden usw., primäre Alkylsulfonate, sekundäre Alkylsulfonate, Alkylsulfonate mit esterartig gebundenen Acylen, Alkyl- bzw. Alkylphenylethersulfonate, Sulfonate von Polycarbonsäureestern, Alkylbenzolsulfonate, Alkylnaphthalinsulfonate, fettaromatische Sulfonate, Alkylbenzimidazolsulfonate, Phosphate, Polyphosphate, Phosphonate, Phosphinate, Thiosulfate, Hydrosulfite, Sulfinate, Persulfate. Geeignete nicht-ionogene Verbindungen sind z.B.: Ester und Ether von Polyalkoholen, Alkylpolyglykolether, Acylpolyglykolether, Alkylarylpolyglykolether, acylierte bzw. alkylierte Alkanolaminpolyglykolether. Geeignete kationenaktive Verbindungen sind z.B.: Alkylaminsalze, quaternäre Ammoniumsalze, Alkylpyridiniumsalze, einfache und quaternäre Imidazolinsalze, Alkyldiamine bzw. Alkylpolyamine, Acyldiamine bzw. Acylpolyamine, Acylalkanolamine, Alkanolaminester, Alkyl-$OCH_2$-N-pyridiniumsalze, Alkyl-CO-NH-$CH_2$-N-pyridiniumsalze, Alkylethylenhamstoffe, Sulfoniumverbindungen, Phosphoniumverbindungen, Arseniumverbindungen, Alkylguanidine, Acylbiguanidide. Geeignete Ampholyte sind z.B.: Alkylbetaine, Sulfobetaine und Aminocarbonsäuren. Bevorzugt eingesetzt werden nichtionogene Tenside, insbesondere die Ethylenoxidadditionsprodukte von Fettalkoholen, Fettaminen sowie von Octyl- oder Nonylphenol.

Eine weitere wichtige Gruppe von eingelagerten Verbindungen sind natürliche Harze und Harzsäuren wie z. B. Abietinsäure und ihre Umwandlungsprodukte und Salze. Solche Umwandlungsprodukte sind z.B. hydrierte, dehydrierte und disproportionierte Abietinsäuren. Diese können weiterhin dimerisiert, polymerisiert oder durch Addition von Maleinsäureanhydrid und Fumarsäure modifiziert sein. Von Interesse sind auch die an der Carboxylgruppe modifizierten Harzsäuren wie z.B. die Methyl-, Hydroxyethyl-, Glykol-, Glycerin- und Pentaerythritester, sowie Harzsäurenitrile und Harzsäureamine sowie Dehydroabietylalkohol.

Ebenfalls für eine Einlagerung geeignet sind Polymere, vorzugsweise wasserlösliche Polymere, z.B. Ethylenpropylenoxid-Blockcopolymere, vorzugsweise mit einem Mn größer gleich 1 000, insbesondere von 1 000 bis 10 000 g/mol, Polyvinylalkohol, Poly(meth)acrylsäuren, modifizierte Cellulose, wie Carboxymethylcellulosen, Hydroxyethyl- und -propylcellulosen, Methyl- und Ethylhydroxyethylcellulosen, ferner Polytetrahydrofuran, aliphatische und/oder aromatische Polyisocyanate sowie Präpolymere aus Polyolen und Isocyanaten mit Molmassen von 1 000 bis 10 000 g/mol.

Ebenfalls für eine Einlagerung geeignet sind Homo- oder Copolymere, insbesondere statistische, Block- oder Pfropf-Copolymere, wasserlösliche oder wasser-emulgierbare Polymere, z.B. Ethylen-Propylenoxid-Block-Copolymere oder Block-Copolymere auf Basis (Poly)hydroxyfettsäuren und Polyalkylenglykol, insbesondere Polyethylenglykol. Bevorzugt werden derartige Polymere mit einem Molekulargewicht von Mn größer gleich 1 000, insbesondere von 1 000 bis 10 000 g/mol. Weiter Polymere sind Polyvinylalkohol, Poly-(meth)acrylsäuren, modifizierte Cellulose, wie Carboxymethylcellulosen, Hydroxyethyl- und -propylcellulosen, Methyl- und Ethylhydroxyethylcellulosen.

Besonders bevorzugt werden als einzulagernde Verbindungen, Melamin oder Melaminderivate, insbesondere solche der Formel (III)

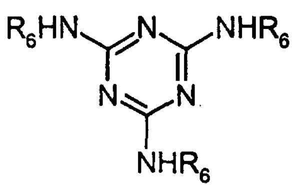

(III)

eingesetzt, worin

$R_6$ für Wasserstoff oder $C_1$-$C_4$-Alkyl, das gegebenenfalls mit OH-Gruppen substituiert ist, steht,

ganz besonders bevorzugt, worin

$R_6$ für Wasserstoff steht.

Die Menge an Substanz, die in das Kristallgitter des Metallkomplexes eingelagert werden kann, liegt in der Regel bei 5 % bis 200 Gew.-%, bezogen auf die Menge an Wirtsverbindung. Bevorzugt eingelagert werden 10 bis 100

Gew.-%. Es handelt sich hierbei um die Menge an Substanz, die durch geeignete Lösungsmittel nicht auswaschbar ist und die sich aus der Elementaranalyse ergibt. Naturgemäß kann auch mehr oder weniger als die genannte Menge an Substanz zugesetzt werden, wobei man gegebenenfalls darauf verzichten kann, einen Überschuss auszuwaschen. Bevorzugt sind Mengen von 10 bis 150 Gew.-%.

Die bevorzugten erfindungsgemäßen Metallkomplexe der Azo-Verbindungen der Formel (I), die eine andere Verbindung eingelagert enthalten, besitzen einen Farbort, der durch die folgenden Bereiche der sogenannten Normfarbwertanteile x und y definiert ist:

Die Farborte werden an Alkyd-Melamin-Lacken nach DIN 53 238 bestimmt, in denen die Pigmente völlig dispergiert vorliegen.

x = 0,38 bis 0,72, vorzugsweise 0,4 bis 0,7
y = 0,14 bis 0,55, vorzugsweise 0,17 bis 0,49

mit

$$x = \frac{X}{X+Y+Z} \qquad y = \frac{Y}{X+Y+Z},$$

wobei
X, Y und Z Normfarbwerte sind.

Das Normfarbsystem ist beschrieben in Bayer Farben Revue, Sonderheft 3/2 D, 1986; S. 12-14.

Einschlussverbindungen, Interkalationsverbindungen und feste Lösungen von Metallkomplexen an sich sind aus der Literatur bekannt. Sie werden ebenso wie deren Herstellung beispielsweise in EP-A-0 074 515 und EP-A-0 073 463 beschrieben.

Die Herstellung dieser Verbindungen kann analog zu der erfolgen, wie sie beispielsweise in EP-A-0 073 464 beschrieben ist. Dabei erfolgt das Verfahren zur Herstellung der oben genannten Metallkomplexe beispielsweise so, dass die Azo-Verbindung der Formel (I), vorzugsweise als Alkalisalz wie Na-, Li- oder K-Salz, mit einem Metallsalz von Metallen ausgewählt aus der Gruppe Li, Cs, Mg, Cd, Co, Al, Cr, Sn, Pb, besonders bevorzugt Na, K, Ca, Sr, Ba, Zn, Fe, Ni, Cu, Mn und La, umgesetzt wird, vorzugsweise bei pH <7, und der entstandene Metallkomplex mit der einzulagernden Verbindung umgesetzt wird, vorzugsweise bei einem pH von 1 bis 7.

Im Anschluss an die Einlagerung kann der pH auf größer gleich 4,5 vorzugsweise auf 4,5 bis 7 angehoben werden, sofern die Einlagerung selbst bei einem pH von kleiner 4,5 erfolgte.

Als Metallsalze kommen vorzugsweise wasserlösliche Metallsalze der oben genannten Metalle in Frage, insbesondere Chloride, Bromide, Acetate, Nitrate usw. Bevorzugt eingesetzte Metallsalze besitzen eine Wasserlöslichkeit von mehr als 20 g/l, insbesondere mehr als 50 g/l bei 20°C.

Geeignete Metallsalze zur Herstellung der Salze und Komplexe der Azo-Verbindungen sind beispielsweise: Magnesiumchlorid, Magnesiumsulfat, Calciumchlorid, Calciumacetat, Calciumformiat, Bariumchlorid, Bariumnitrat, Bariumacetat, Bariumcarbonat, Strontiumnitrat, Manganchlorid, Mangansulfat, Eisen-(III)-chlorid, Eisen-(III)-nitrat, Eisen-(II)-sulfat, Cobaltchlorid, Cobaltnitrat, Cobaltsulfat, Nickelnitrat, Nickelsulfat, Nickelchlorid, Nickelacetat, Nickelformiat, Aluminiumsulfat, Aluminiumnitrat, Chrom-(III)-sulfat, Chrom-(III)-nitrat, Zinkchlorid, Zinksulfat, Zinkacetat, Cadmiumchlorid, Cadmiumsulfat, Cadmiumnitrat; Kupfer-(II)-sulfat, Kupfer-(II)-chlorid, Kupfer-(II)-acetat und Kupfer-(II)-formiat, Lanthannitrat und Aluminiumchloridhydrat.

Man kann auch Mischungen dieser Salze, die verschiedene der genannten Metalle enthalten können, verwenden. Die Verwendung von solchen Salzmischungen empfiehlt sich insbesondere für die Erzielung von Zwischentönen der farbigen Endprodukte.

Die auf diese Weise erhaltenen Metallkomplexe können dann durch Filtration ihrer wässrigen Suspension als wässriger Presskuchen isoliert werden. Dieser Presskuchen kann, beispielsweise nach Waschen mit heißem Wasser, nach üblichen Trocknungsverfahren getrocknet werden.

Als Trocknungsverfahren kommen beispielsweise die Schaufeltrocknung oder die Sprühtrocknung entsprechender wässriger Slurrys in Frage.

Anschließend kann das Pigment nachgemahlen werden.

Sofern die Metallkomplexe für die erfindungsgemäße Anwendung zu kornhart bzw. zu dispergierhart sind, können sie beispielsweise gemäß der in DE-A-19 847 586 beschriebenen Methode in kornweiche Pigmente umgewandelt werden.

Dabei wird vorzugsweise der wässrige Presskuchen als wässriger Slurry sprühgetrocknet, wobei der Slurry vorzugsweise Ammoniak und/oder eine anorganische oder organische Base enthält.

Bevorzugt ist es ebenfalls, die erfindungsgemäß verwendeten Metallkomplexe, sofern sie eine Dispergierhärte von >250 besitzen in Gegenwart von Wasser und gegebenenfalls organischen Lösungsmitteln entweder bei

einem pH von 1 bis 4, vorzugsweise 1 bis 3, insbesondere 1,5 bis 2,5 oder bei einem pH von 9 bis 13, vorzugsweise von 10 bis 11 und bei einer Temperatur von 80 bis 180°C, vorzugsweise 90 bis 140°C, insbesondere bei 95 bis 110°C zu tempern.

Im Rahmen dieser Anmeldung werden die Metallkomplexe einer Azo-Verbindung der Formel (I), die wenigstens eine Verbindung eingelagert enthalten, als Pigmente bezeichnet.

Die Pigmente werden vorzugsweise in Form ihrer Pigmentpräparationen enthaltend weitere Zusätze angewendet.

Die Erfindung betrifft daher auch Pigmentpräparationen, enthaltend

a) wenigstens ein Pigment aus der Gruppe der Metallkomplexe einer Azo-Verbindung der Formel (I), die eine andere Verbindung eingeschlossen enthalten und

b) eine organische Verbindung ausgewählte aus der Gruppe der Terpene, Terpenoide, Fettsäuren, Fettsäureester und der Homo- oder Copolymere, wie statistische- oder Block-Copolymere mit einer Löslichkeit in pH neutralem Wasser bei 20°C von weniger als 1 g/l, insbesondere weniger als 0,1 g/l.

Besonders bevorzugt sind die erfindungsgemäßen Pigmentpräparationen in fester Form, vorzugsweise in Form von Pulver oder Granulat.

Die organische Verbindung der Komponente (b) ist vorzugsweise bei Normalatmosphäre fest oder flüssig und weist im Falle flüssig einen Siedepunkt von vorzugsweise >100°C, insbesondere >150°C auf sowie im Falle fest einen Schmelzpunkt von vorzugsweise <150°C, insbesondere <100°C.

Bevorzugte Polymere besitzen sowohl einen hydrophilen wie auch einen hydrophoben vorzugsweise polymeren Molekülteil. Beispiele derartiger Polymere sind statistische Copolymere auf Basis von Fettsäuren oder langkettigen ($C_{12}$-$C_{22}$) Kohlenwasserstoffen und Polyalkylenglykolen, insbesondere Polyethylenglykol. Ferner Block-Copolymere auf Basis von (Poly)Hydroxy Fettsäuren und Polyalkylenglykol, insbesondere Polyethylenglykol sowie Pfropf-Copolymere auf Basis von Poly(meth)acrylat und Polyalkylenglykol, insbesondere Polyethylenglykol.

Als bevorzugte Verbindungen aus der Gruppe der Terpene, Terpenoide, Fettsäuren und Fettsäureester seien genannt: Ocimen, Myrcen, Geraniol, Nerol, Linalool, Cirtonellol, Geranial, Citronellal, Neral, Limonen, Menthol, beispielsweise (-)-Menthol, Menthon oder bicyclische Monoterpene, gesättigte und ungesättigte Fettsäuren mit 6 bis 22 C-Atomen, wie beispielsweise Ölsäure, Linolsäure und Linolensäure oder Mischungen davon.

Als organische Verbindungen der Komponente (b) kommen ferner auch die oben im Zusammenhang mit den weiter oben genannten Einschluss-Verbindungen genannten infrage soweit sie den für die Verbindung der Komponente (b) gewünschten Kriterien gehorchen.

Sofern die einzulagernde Verbindung und die Verbindung der Komponente b) identisch sind, differenziert man über die Auswaschbarkeit der Verbindung b) mit einem geeigneten Lösungsmittel.

Bevorzugte Pigmentpräparationen enthalten:

| | |
|---|---|
| 50 - 99 Gew.-% | wenigstens ein Pigment der Komponente (a) aus der Gruppe der Metallkomplexe einer Azo-Verbindung der Formel I, die wenigstens eine andere Verbindung eingeschlossen enthalten und |
| 1 - 100 Gew.-% | vorzugzweise 2 bis 50 Gew.-%, bezogen auf das Pigment der Komp. (a), wenigstens eine Verbindung der Komponente (b) |

Gegebenenfalls enthält die erfindungsgemäße Pigmentpräparation zusätzlich ein oberflächenaktives Mittel (c).

Geeignete oberflächenaktive Mittel (c) sind beispielsweise anionischer, kationischer, amphoterer oder nichtionogener Natur.

Geeignete anionische oberflächenaktive Mittel sind insbesondere Kondensationsprodukte von aromatischen Sulfonsäuren mit Formaldehyd, wie Kondensationsprodukte aus Formaldehyd und Alkylnaphthalinsulfonsäuren oder aus Formaldehyd, Naphthalinsulfonsäuren und/oder Benzolsulfonsäuren, Kondensationsprodukte aus gegebenenfalls substituiertem Phenol mit Formaldehyd und Natriumbisulfit. Geeignet sind außerdem oberflächenaktive Mittel aus der Gruppe der Sulfobernsteinsäureester sowie Alkylbenzolsulfonate. Außerdem ionisch modifizierte, insbesondere sulfatierte oder carboxilierte, alkoxylierte Fettsäurealkohole oder deren Salze. Als alkoxylierte Fettsäurealkohole werden insbesondere solche mit 5 bis 120, vorzugsweise 5 bis 60, insbesondere mit 5 bis 30 Ethylenoxid versehene $C_6$-$C_{22}$-Fettsäurealkohole, die gesättigt oder ungesättigt sind, verstanden. Weiterhin kommen vor allem Ligninsulfonate in Betracht, z.B. solche, die nach dem Sulfit- oder Kraft-Verfahren gewonnen werden. Vorzugsweise handelt es sich um Produkte, die zum Teil hydrolysiert, oxidiert, propoxyliert, sulfoniert, sulfomethyliert oder desulfoniert und nach bekannten Verfahren fraktioniert werden, z.B. nach dem Molekulargewicht oder nach dem Sulfonierungsgrad. Auch Mischungen aus Sulfit- und Kraftligninsulfonaten sind gut wirksam. Besonders geeignet sind Ligninsulfonate mit einem durchschnittlichen Molekulargewicht zwischen 1 000 und 100 000 g/mol, einem Gehalt an aktivem Ligninsulfonat von mindestens 80 Gew.-% und vorzugsweise mit niedrigem Gehalt an mehrwertigen Kationen. Der Sulfonierungsgrad kann in weiten Grenzen variieren.

Als nichtionische oberflächenaktive Mittel kommen beispielsweise in Frage: Umsetzungsprodukte von Alkylenoxiden mit alkylierbaren Verbindungen, wie z.B. Fettalkoholen, Fettaminen, Fettsäuren, Phenolen, Alkylphenolen, Arylalkylphenolen, wie Styrol-Phenol-Kondensate, Carbonsäureamiden und Harzsäuren. Hierbei handelt es sich z.B. um Ethylenoxidaddukte aus der Klasse der Umsetzungsprodukte von Ethylenoxid mit:

a1) gesättigten und/oder ungesättigten Fettalkoholen mit 6 bis 22 C-Atomen oder

b1) Alkylphenolen mit 4 bis 12 C-Atomen im Alkylrest oder

c1) gesättigten und/oder ungesättigten Fettaminen mit 14 bis 20 C-Atomen oder

d1) gesättigten und/oder ungesättigten Fettsäuren mit 14 bis 20 C-Atomen oder

e1) hydrierte und/oder unhydrierte Harzsäuren.

Als Ethylenoxid-Addukte kommen insbesondere die unter al) bis el) genannten alkylierbaren Verbindungen mit 5 bis 120, insbesondere 5 bis 100, insbesondere 5 bis 60, besonders bevorzugt 5 bis 30 Mol Ethylenoxid in Frage.

Als oberflächenaktive Mittel eignen sich ebenfalls die aus DE-A 19 712 486 oder aus DE-A 19 535 246 bekannten Ester des Alkoxylierungsproduktes der Formel (X), die der Formel (XI) entsprechen sowie diese gegebenenfalls in Mischung mit den zugrundeliegenden Verbindungen der Formel (X). Das Alkoxylierungsprodukt eines Styrol-Phenol-Kondensats der Formel (X) ist wie nachfolgend definiert:

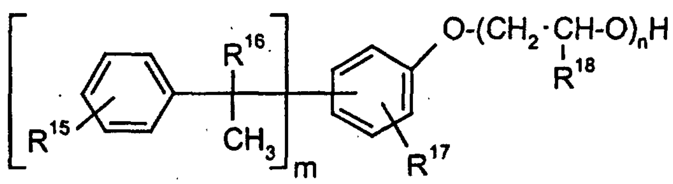

(X),

in der

$R^{15}$ Wasserstoff oder $C_1$-$C_4$-Alkyl bedeutet,

$R^{16}$ für Wasserstoff oder $CH_3$ steht,

$R^{17}$ Wasserstoff, $C_1$-$C_4$-Alkyl, $C_1$-$C_4$-Alkoxy, $C_1$-$C_4$-Alkoxycarbonyl oder Phenyl bedeutet,

m eine Zahl von 1 bis 4 bedeutet,

n eine Zahl von 6 bis 120 bedeutet,

$R^{18}$ für jede durch n indizierte Einheit gleich oder verschieden ist und für Wasserstoff, $CH_3$ oder Phenyl steht, wobei im Falle der Mitanwesenheit von $CH_3$ in den verschiedenen $-(-CH_2-CH(R^{18})-O-)$-Gruppen in 0 bis 60 % des Gesamtwertes von n $R^{18}$ für $CH_3$ und in 100 bis 40 % des Gesamtwertes von n $R^{18}$ für Wasserstoff steht und wobei im Falle der Mitanwesenheit von Phenyl in den verschiedenen $-(-CH_2-CH(R^{18})-O-)$-Gruppen in 0 bis 40 % des Gesamtwertes von n $R^{18}$ für Phenyl und in 100 bis 60 % des Gesamtwertes von n $R^{18}$ für Wasserstoff steht.

Die Ester der Alkoxylierungsprodukte (X) entsprechen der Formel (XI)

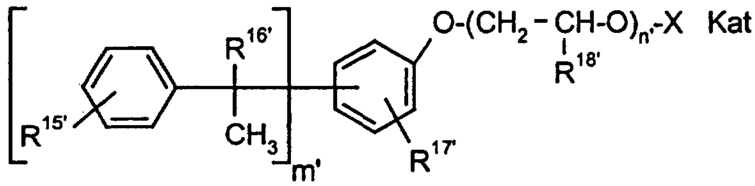

(XI),

in der

| | |
|---|---|
| $R^{15'}$, $R^{16'}$, $R^{17'}$, $R^{18'}$, m' und n' | den Bedeutungsumfang von $R^{15}$, $R^{16}$, $R^{17}$, $R^{18}$, m bzw. n, jedoch unabhängig hiervon, annehmen, |
| X - | die Gruppe $-SO_3$, $-SO_2$, $-PO_3$ oder $-CO-(R^{19})-COO$ bedeutet, |
| Kat | ein Kation aus der Gruppe von H, Li, Na, K, $NH_4$ oder $HO-CH_2CH_2-NH_3$ ist, wobei im Falle von X = $-PO_3$ zwei Kat vorliegen und |
| $R^{19}$ | für einen zweiwertigen aliphatischen oder aromatischen Rest steht, vorzugsweise für $C_1$-$C_4$-Alkylen, insbesondere Ethylen, $C_2$-$C_4$- einfach ungesättigte Reste, insbesondere Acetylen oder gegebenenfalls substituiertes Phenylen, insbesondere ortho-Phenylen steht, wobei als mögliche Substituenten vorzugsweise $C_1$-$C_4$-Alkyl, $C_1$-$C_4$-Alkoxy, $C_1$-$C_4$-Alkoxycarbonyl oder Phenyl in Frage kommen. |

Spezielle Einzelverbindungen der Formel (XI) sind beispielsweise aus DE-A 19 712 486 und Gemische der Formeln (X) und (XI) sind beispielsweise DE-A-19 535 246 bekannt, die jeweils Bestandteile dieser Anmeldung sind.

Als ein bevorzugtes oberflächenaktive Mittel wird die Verbindung der Formel (XI) eingesetzt. Vorzugsweise eine Verbindung der Formel (XI), worin X einen Rest der Formel $-CO-(R^{19})-COO-$ bedeutet und $R^{19}$ die obige Bedeutung besitzt.

Bevorzugt ist es ebenfalls als oberflächenaktive Mittel eine Verbindung der Formel (XI) zusammen mit einer Verbindung der Formel (X) einzusetzen. Vorzugsweise enthält das oberflächenaktive Mittel in diesem Fall 5 bis 99 Gew.-% der Verbindung (XI) und 1 bis 95 Gew.-% der Verbindung (X).

Das oberflächenaktive Mittel der Komponente c) wird vorzugsweise in einer Menge von 0,1 bis 100 Gew.-%, insbesondere 0,5 bis 60 Gew.-%, bezogen auf das eingesetzte Pigment der Komponente a), verwendet.

Selbstverständlich kann die erfindungsgemäße Präparation noch weitere Zusätze enthalten. So können beispielsweise viskositätserniedrigende oder feststofferhöhende Zusätze im Verlauf der Herstellung wässriger Suspensionen in einer Menge von bis zu 10 Gew.-%, bezogen auf die Präparation, eingebracht werden.

Weitere Zusätze sind beispielsweise anorganische und organische Basen sowie für Pigmentpräparation übliche Zusätze.

Als Basen sind zu nennen: Alkalihydroxide, wie beispielsweise NaOH, KOH oder organische Amine wie Alkylamine, insbesondere Alkanolamine oder Alkylalkanolamine.

Als besonders bevorzugt sind zu nennen Methylamin, Dimethylamin, Trimethylamin, Ethanolamin, n-Propanolamin, n-Butanolamin, Diethanolamin, Triethanolamin, Methylethanolamin oder Dimethylethanolamin.

Als Carbonsäure- und Sulfonsäureamide sind beispielsweise geeignet: Harnstoff und substituierte Harnstoffe wie Phenylharnstoff, Dodecylharnstoff und andere; Heterocyclen wie Barbitursäure, Benzimidazolon, Benzimidazolon-5-sulfonsäure, 2,3-Dihydroxychinoxalin, 2,3-Dihydroxychinoxalin-6-sulfonsäure, Carbazol, Carbazol-3,6-disulfonsäure, 2-Hydroxychinolin, 2,4-Dihydroxychinolin, Caprolactam, Melamin, 6-Phenyl-1,3,5-triazin-2,4-diamin, 6-Methyl-1,3,5-triazin-2,4-diamin, Cyanursäure.

Die Base ist gegebenenfalls bis zu einer Menge von 20 Gew.-%, vorzugsweise bis 10 Gew.-%, bezogen auf Pigment der Komponente a), enthalten.

Weiterhin können die Pigmentpräparationen herstellungsbedingt noch anorganische und/oder organische Salze enthalten.

Besonders bevorzugt enthalten die erfindungsgemäßen Präparationen mehr als 90 insbesondere mehr als 95, vorzugsweise mehr als 97 Gew.-% an Pigment der Komponente a), organische Verbindung der Komponente b) und gegebenenfalls oberflächenaktives Mittel der Komponente c) und/oder Base.

Ein Verfahren zur Herstellung der erfindungsgemäßen Pigmentpräparationen ist dadurch gekennzeichnet,

dass man das Pigment der Komponente a), also wenigstens ein Pigment aus der Gruppe der Metallkomplexe einer Azo-Verbindung der Formel I, die wenigstens eine andere Verbindung eingeschlossen enthält, eine Verbindung der Komponente b) und gegebenenfalls ein oberflächenaktives Mittel der Komponente c) sowie gegebenenfalls weitere Zusätze in Wasser bei einem pH > 6,5, insbesondere >7 und einer Temperatur von 20 bis 105°C, vorzugsweise 20 bis 95°C und insbesondere oberhalb der Schmelztemperatur der Komponente b) homogenisiert, anschließend gegebenenfalls den pH auf einen Wert <6,5, insbesondere <5 einstellt, und die wässrige Suspension gegebenenfalls nach Abkühlung durch Filtration als wässrigen Presskuchen isoliert und gegebenenfalls trocknet. Die Homogenisierung erfolgt vorzugsweise mittels Intensivmischer oder Dissolver, Schnellrührer, Scherspaltmischer oder Kavitron, Kugel- oder Perlmühle oder Hochdruckhomogenisator.

Der Presskuchen kann beispielsweise nach Waschen mit heißem und/oder kaltem Wasser, nach üblichen Trocknungsverfahren zu der erfindungsgemäß zu verwendenden festen Pigmentpräparation getrocknet werden.

Als Trocknungsverfahren kommen beispielsweise die Blechtrocknung, Schaufeltrocknung, oder die Sprühtrocknung entsprechend eingestellter wässriger Slurrys in Frage.

Anschließend kann die feste Pigmentpräparation nachgemahlen werden.

Die erfindungsgemäße Verwendung der oben beschriebenen Pigmente bzw. die der erfindungsgemäßen Pigmentpräparationen zur Herstellung von Farbfiltern für Flüssigkristall anzeigen sei im Folgenden am Beispiel der Pigment-Dispersionsmethode nach dem Photolackverfahren beschrieben.

Die erfindungsgemäße Verwendung der Pigmente bzw. der erfindungsgemäßen Pigmentpräparationen zur Herstellung von Farbfiltern ist beispielsweise dadurch gekennzeichnet, dass das Pigment oder die Pigmentpräparation, insbesondere die feste Pigmentpräparation, gegebenenfalls mit einem Bindemittelharz und einem organischen Lösungsmittel, ggf. unter Zusatz eines Dispergiermittels, homogenisiert und anschließend kontinuierlich oder diskontinuierlich auf eine Teilchengröße nach Anzahl (elektronenmikroskopische Bestimmung) von 99,5 % <1000 nm, vorzugsweise 95 % <500 nm und insbesondere 90 % <200 nm nasszerkleinert wird.

Als Nasszerkleinerungsverfahren kommen beispielsweise Rührer- oder Dissolverdispergierung, Mahlen mittels Rührwerkskugel- oder perlmühlen, Kneter, Walzenstuhl, Hochdruckhomogenisierung oder Ultraschalldispergierung in Frage.

Während der Dispergierbehandlung oder im Anschluss daran erfolgt die Zugabe von mindestens einem photohärtbaren Monomeren und einem Photoinitiator. Im Anschluss an die Dispergierung kann noch weiteres Bindemittelharz, Lösungsmittel oder für Photolacke übliche Zuschlagstoffe eingebracht werden, wie es für die gewünschte photosensitive Beschichtungsmitteleinstellung (Photolack) zur Herstellung der Farbfilter erforderlich ist. Im Rahmen dieser Erfindung wird unter Photolack eine Präparation verstanden, die wenigstens ein photohärtbares Monomer und einen Photoinitiator enthält.

Als mögliche Dispergiermittel kommen allgemein handelsübliche wie beispielsweise polymere, ionogene oder nicht-ionogene Dispergiermittel bspw. auf Basis von Polycarbonsäuren oder Polysulfonsäuren, sowie Polyethylenoxid-Polypropylenoxid-Block-Copolymere in Betracht. Ferner können auch Derivate organischer Farbstoffe als Dispergiermittel oder Co-Dispergiermittel verwendet werden.

Bei der Herstellung der Farbfilter fallen daher Zubereitungen an und bezogen auf die Zubereitung enthalten:

- wenigstens ein Pigment im obigen Sinne oder wenigstens eine erfindungsgemäße Pigmentpräparation,
- gegebenenfalls ein Bindemittelharz,
- wenigstens ein organisches Lösungsmittel sowie
- gegebenenfalls ein Dispergiermittel.

In einer bevorzugten Ausführungsform enthält die Zubereitung (Angaben bezogen auf Präparation):

| | |
|---|---|
| 1 - 50 Gew.-% | wenigstens ein Pigment der Komponente a) oder eine erfindungsgemäße Pigmentpräparation |
| 0 - 20 Gew.-% | Bindemittelharz |
| 0 - 20 Gew.-% | Dispergiermittel |
| 10 - 94 Gew.-% | organisches Lösungsmittel |

Die Beschichtung des Photolackes auf eine Platte zur Erzeugung der gefärbten Bildelementmuster kann entweder durch direkten oder indirekten Auftrag geschehen. Als Auftragsmethoden seien bspw. genannt: Roller-Coating, Spin-Coating, Spray-Coating, Dip-Coating und Air-Knife-Coating.

Als Platten kommen je nach Verwendung beispielsweise in Frage: transparente Gläser wie weiße oder blaue

Glasplatte, mit Silikat beschichtete blaue Glasplatte, Kunstharzplatte oder -filme auf Basis von z.B. Polyester-, Polycarbonat-, Acryl-, oder Vinylchloridharz, ferner Metallplatten auf Basis von Aluminium, Kupfer, Nickel, oder Stahl sowie Keramikplatten oder Halbleiterplatten mit aufgebrachten photoelektrischen Transferelementen.

Die Auftragung erfolgt im Allgemeinen so, dass die Schichtdicke der erhaltenen photosensitiven Schicht bei 0,1 bis 10 μm liegt.

Im Anschluss an den Auftrag kann eine thermische Trocknung der Schicht erfolgen.

Die Belichtung erfolgt vorzugsweise, indem die photosensitive Schicht einem aktiven Lichtstrahl vorzugsweise in Form eines Bildmusters mittels Photomaske ausgesetzt wird. Hierdurch wird an den belichteten Stellen die Schicht gehärtet. Geeignete Lichtquellen sind z.B.: Hochdruck- und Ultrahochdruckquecksilberdampflampe, Xenon-, Metallhalogenid-, Fluoreszenzlampe sowie Laserstrahl im sichtbaren Bereich.

Durch die Entwicklung im Anschluss an die Belichtung wird der unbelichtete Teil der Beschichtung entfernt und man erhält die gewünschte Bildmusterform der Farbelemente. Übliche Entwicklungsmethoden umfassen das Besprühen mit oder Tauchen in wässrige alkalische Entwicklerlösung oder in ein organisches Lösungsmittel, das anorganische Alkali wie z.B. Natrium- oder Kaliumhydroxid, Natriummetasilikat oder organische Basen wie Monoethanolamin, Diethanolamin, Triethanolamin, Triethylamin oder deren Salze enthält.

Nach der Entwicklung erfolgt in der Regel eine thermische Nachtrocknung/-härtung der Bildmuster.

Weitere Pigmente:

Die Verwendung der Pigmente der Komponente a) ist vorzugsweise dadurch gekennzeichnet, dass entweder einzelne Metallkomplexe einer Azo-Verbindung der Formel (I), die wenigstens eine Verbindung eingelagert enthalten oder die darauf basierenden erfindungsgemäßen festen Pigmentpräparationen alleine oder in Mischung mit "anderen Pigmenten" in den Farbfiltern bzw. Pigmentpräparationen für Farbfilter eingesetzt werden.

Wie oben erwähnt können auch Mischungen verschiedener Metallsalze zur Herstellung der erfindungsgemäß zu verwendenden Pigmente der Komponente a) oder der darauf basierenden erfindungsgemäßen festen Pigmentpräparationen in Frage kommen.

Unter "andere Pigmente" seien sowohl andere Metallsalze einer Azo-Verbindung der Formel (I) oder darauf basierende feste Pigmentpräparationen verstanden als auch andere organische Pigmente.

Hinsichtlich der Auswahl anderer ggf. mitzuverwendender Pigmente besteht erfindungsgemäß keine Einschränkung. Es kommen sowohl anorganische als auch organische Pigmente in Frage.

Bevorzugte organische Pigmente sind z.B. solche der Monoazo-, Disazo-, verlackte Azo-, β-Naphthol-, Napthol AS-, Benzimidazolon-, Disazokondensations-, Azometallkomplex-, Isoindolin- und Isoindolinon-Reihe, ferner polycyclische Pigmente wie z.B. aus der Phthalocyanin-, Chinacridon-, Perylen-, Perinon-, Thioindigo-, Anthrachinon-, Dioxazin-, Chinophthalon- und Diketopyrrolopyrrol-Reihe. Außerdem verlackte Farbstoffe wie Ca-, Mg- und Al-Lacke von sulfonsäure- oder carbonsäuregruppenhaltigen Farbstoffen.

Beispiele für gegebenenfalls mitzuverwendende andere organische Pigmente sind:

gelbe Pigmente vom
Color Index Pigment Yellow 12, 13, 14, 17, 20, 24, 74, 83, 86, 93, 94, 109, 110, 117, 125, 137, 138, 139, 147, 148, 150, 153, 154, 166, 173, 185, oder
Color Index Pigment Orange 13, 31, 36, 38, 40, 42, 43, 51, 55, 59, 61, 64, 65, 71, 72, 73 oder
Color Index Pigment Red 9, 97, 122, 123, 144, 149, 166, 168, 177, 180, 192, 215, 216, 224, 254, 272, oder
Color Index Pigment Green 7, 10, 36, 37, 45, oder
Color Index Pigment Blue 15, 15:1, 15:2, 15:3, 15:4, 15:6, 16 sowie
Color Index Pigment Violett 19, 23.

Sofern "andere Pigmente" zusätzlich eingesetzt werden, beträgt der Anteil von Metallkomplexpigmenten einer Verbindung (I), die wenigstens eine Verbindung eingelagert enthalten oder darauf basierende feste Pigmentpräparationen in Mischungen mit anderen Pigmenten vorzugsweise 1-99 Gew.-%, insbesondere 5-60 Gew.-% bezogen auf die eingesetzte Gesamtmenge aller Pigmente.

Als Bindemittelharze, die zusammen mit dem Pigment der Komponente a) oder darauf basierender fester Pigmentpräparationen in Farbfiltern bzw. in den Zubereitungen zur Herstellung von Farbfiltern z.B. nach der Pigment-Dispersionsmethode, eingesetzt werden können, besteht erfindungsgemäß keine besondere Einschränkung, insbesondere kommen für die Anwendung in Farbfiltern an sich bekannte filmbildende Harze in Frage.

Beispielsweise kommen Bindemittelharze aus der Gruppe der Celluloseharze wie Carboxymethylhydroxyethylcellulose und Hydroxyethylcellulose, Acrylharze, Alkydharze, Melaminharze, Epoxidharze, Polyvinylalkohole, Polyvinylpyrrolidone, Polyamide, Polyamidimine, Polyimide, Polyimidvorstufen wie solche der Formel (14), offenbart in JP-A 11 217 514 und deren Veresterungsprodukte in Frage.

Als solche sind beispielsweise Umsetzungsprodukte von Tetracarbonsäuredianhydrid mit Diaminen zu nennen.

Als Bindemittelharze kommen auch solche in Frage, die photopolymerisierbare, ungesättigte Bindungen enthalten. Die Bindemittelharze können beispielsweise solche aus der Gruppe der Acrylharze aufgebaut sein. Dabei sind insbesondere Mono- und Copolymere polymerisierbarer Monomere zu nennen wie z.B. (Meth)acrylsäuremethylester, (Meth)acrylsäureethylester, (Meth)acrylsäurepropylester, (Meth)acrylsäurebutylester, Styrol und Styrolderivate, ferner Copolymere zwischen carboxylgruppentragenden polymerisierbaren Monomeren wie (Meth)acrylsäure, Itaconsäure, Maleinsäure, Maleinsäureanhydrid, Maleinsäuremonoalkylester, insbesondere mit Alkyl von 1 bis 12 C-Atomen, und polymerisierbare Monomere wie (Meth)acrylsäure, Styrol und Styrolderivate, wie z.B. $\alpha$-Methylstyrol, m- oder p-Methoxystyrol, p-Hydroxystyrol. Als Beispiele seien genannt Umsetzungsprodukte von carboxylgruppenhaltigen polymeren Verbindungen mit Verbindungen, die jeweils einen Oxiranring und eine ethylenisch ungesättigte Verbindung enthalten wie z.B. Glycidyl(meth)acrylat, Acrylglycidylether und Itaconsäuremonoalkylglycidylether usw., ferner Umsetzungsprodukte von carboxylgruppenhaltigen polymeren Verbindungen mit Verbindungen, die jeweils eine Hydroxylgruppe und eine ethylenisch ungesättigte Verbindung (ungesättigte Alkohole) enthalten wie Allylalkohol, 2-Buten-4-ol, Oleylalkohol, 2-Hydroxyethyl(meth)acrylat, N-Methylolacrylamid usw.;
weiterhin können derartige Bindemittelharze auch ungesättigte Verbindungen, die freie Isocyanatgruppen besitzen, enthalten.

Im Allgemeinen liegt die Äquivalenz der Ungesättigtheit (Molgewicht Bindemittelharz pro ungesättigte Verbindung) der genannten Bindemittelharze bei 200 bis 3 000, insbesondere 230 bis 1 000, um sowohl eine ausreichende Photopolymerisierbarkeit und Härte des Films zu erreichen. Der Säurewert liegt im Allgemeinen bei 20 bis 300, insbesondere 40 bis 200, um eine genügende Alkali-Entwicklungsfähigkeit nach der Belichtung des Films zu erzielen.

Das mittlere Molgewicht der einzusetzenden Bindemittelharze liegt zwischen 1 500 und 200 000, insbesondere 10 000 bis 50 000 g/mol.

Die bei der erfindungsgemäßen Verwendung der Pigmente bzw. Pigmentpräparationen für Farbfilter eingesetzten organischen Lösungsmittel sind z.B. Ketone, Alkylenglykolether, Alkohole und aromatische Verbindungen. Beispiele aus der Gruppe der Ketone sind: Aceton, Methylethylketon, Cyclohexanon etc.; aus der Gruppe der Alkylenglykolether: Methylcellosolye (Ethylenglykolmonomethylester), Butylcellosolve (Etylenglykolmonobutylether) Methylcellosolveacetat, Ethylcellosolveacetat, Butylcellosolveacetat, Ethylenglykolmonopropylether, Ethylenglykolmonohexylether, Ethylenglykoldimethylether, Diethylenglykolethylether, Diethylenglykoldiethylether, Propylenglykolmonomethylether, Propylenglykolmonoethylether, Propylenglykolmonopropylether, Propylenglykolmonobutylether, Propylenglykolmonomethyletheracetat, Diethylenglykolmethyletheracetat, Diethylenglykolethyletheracetat, Diethylenglykolpropyletheracetat, Diethylenglykolisopropyletheracetat, Diethylenglykolbutyletheracetat, Diethylenglykol-t-butyletheracetat, Triethylenglykolmethyletheracetat, Triethylenglykolethyletheracetat, Triethylenglykolpropyletheracetat, Triethylenglykolisopropyletheracetat, Triethylenglykolbutyletheracetat, Triethylenglykol-t-butyletheracetat, etc.;
aus der Gruppe der Alkohole: Methylalkohol, Ethylalkohol, Isopropylalkohol, n-Butylalkohol, 3-Methyl-3-methoxybutanol, etc.;
aus der Gruppe der aromatischen Lösungsmittel Benzol, Toluol, Xylol, N-Methyl-2-Pyrrolidon, N-Hydroxymethyl-2-Essigsäureethylester, etc..

Weitere andere Lösungsmittel sind 1,2-Propandioldiacetat, 3-Methyl-3-methoxybutylacetat, Essigsäureethylester, Tetrahydrofuran, etc.. Die Lösungsmittel können einzeln oder in Gemischen untereinander eingesetzt werden.

Die Erfindung betrifft weiterhin einen Photolack, enthaltend wenigstens ein Pigment im obigen Sinne oder wenigstens eine erfindungsgemäße Pigmentpräparation und wenigstens ein photohärtbares Monomer sowie wenigstens einen Photoinitiator.

Die photohärtbaren Monomere enthalten im Molekül wenigstens eine reaktive Doppelbindung und gegebenenfalls andere reaktive Gruppen.

Als photohärtbare Monomere seien in diesem Zusammenhang insbesondere reaktive Lösungsmittel bzw. sog. Reaktiwerdünner verstanden z.B. aus
der Gruppe der mono-, di- , tri- und multifunktionelle Acrylate und Methacrylate, Vinylether, sowie Glycidylether. Als zusätzlich enthaltene reaktive Gruppen kommen in Frage Allyl-, Hydroxy-, Phosphat-, Urethan-, sek. Amin- und N-Alkoxymethylgruppen.

Derartige Monomere sind dem Fachmann bekannt und beispielsweise in *[Römpp Lexikon, Lacke und Druckfarben, Dr. Ulrich Zorll, Thieme Verlag Stuttgart-New York, 1998, S. 491/492*] aufgeführt. Die Auswahl der Monomere richtet sich insbesondere nach der Art und Intensität der verwendeten Strahlenart der Belichtung, der gewünschten Reaktion mit dem Photoinitiator und den Filmeigenschaften. Es können auch Kombinationen von Monomeren eingesetzt werden.

Als Photoreaktionsstarter oder Photoinitiatoren seinen Verbindungen verstanden, die infolge der Adsorption sichtbarer oder ultravioletter Strahlung reaktive Zwischenprodukte bilden, die eine Polymerisationsreaktion beispielsweise der oben genannten Monomeren und/oder Bindemittelharze auslösen können. Photoreaktionsstarter sind ebenfalls allgemein bekannt und können ebenfalls aus [*Römpp Lexikon, Lacke und Druckfarben, Dr. Ulrich Zorll, Thieme Verlag Stuttgart-New York, 1998, S. 445/446*] entnommen werden.

Erfindungsgemäß besteht keine Einschränkung hinsichtlich der einzusetzenden photohärtbaren Monomeren oder Photoinitiatoren.

Die Erfindung betrifft bevorzugt Photolacke enthaltend

a) wenigstens ein Pigment aus der Klasse der Metallkomplexe einer Azo-Verbindung der Formel I, die wenigstens eine weitere Verbindung eingelagert enthalten oder darauf basierende erfindungsgemäße feste Pigmentpräparation,

b1) wenigstens ein photohärtbares Monomer,

b2) wenigstens einen Photoinitiator,

c1) gegebenenfalls ein organisches Lösungsmittel,

d) gegebenenfalls ein Dispergiermittel,

e) gegebenenfalls ein Bindemittelharz,

sowie gegebenenfalls weitere Zusätze.

Erfindungsgemäß besteht auch keine Einschränkung hinsichtlich der Technologie zur Erzeugung der gefärbten Bildelementmuster auf Basis der erfindungsgemäß zu verwendenden Pigmente oder feste Pigmentpräparationen. Neben dem oben beschriebenen photolithographischen Verfahren sind andere Verfahren wie Offset-Druck, chemisches Ätzen oder Ink-Jet-Druck ebenso geeignet. Die Auswahl der geeigneten Bindemittelharze und Lösungsmittel bzw. Pigment-Trägermedien sowie weitere Zusätze sind auf das jeweilige Verfahren abzustimmen. Beim Ink-Jet-Verfahren, worunter sowohl der thermische als auch mechanische und piezzo-mechanische Ink-Jet-Druck verstanden werden, kommen neben rein organischen auch wässrig-organische Trägermedien für die Pigmente und ggf. Bindemittelharze in Frage, wässrig-organische Trägermedien werden sogar bevorzugt.

**Beispiele**

**Beispiel 1:**

Herstellung einer Einschlussverbindung des Pigmentes gemäß Formel (Ia), worin Me = Ni, $R^1 = R^{1'}$ = O, R = R' = OH, die Melamin eingelagerten enthält: grünstichig gelbes Pigment

25 g Benzolsulfonsäurehydrazid, 200 ml Wasser, 20 ml 10N Salzsäure und 1,25 g eines Kondensationsproduktes von Stearinsäure mit Taurin wurden 30 Minuten verrührt. Man fügte 60 g Eis hinzu und tropfte anschließend in ca. 30 Minuten 34 ml einer wässrigen Natriumnitritlösung mit einem Gehalt von 30 g Natriumnitrit in 100ml Lösung hinzu. Der Ansatz wurde 30 Minuten gerührt, wobei man einen Nitritüberschuss aufrechterhielt. Anschließend zerstörte man den Nitritüberschuss mit wenig Amidosulfonsäure und neutralisierte mit ca. 5 ml 10 N Natronlauge. Man erhielt eine Emulsion von Benzolsulfonsäureazid.

Zu der so eingestellten Emulsion gab man 38,2 g Barbitursäure, verrührte 10 Minuten und stellte dann mit ca. 33 ml 10 N Natronlauge auf pH 8. Der Ansatz wurde 2 Stunden bei 50°C gerührt, danach mit 3 ml Essigsäure und ca. 14 ml 10 N Salzsäure auf pH 4,8 gestellt und noch eine Stunde auf 70°C und 3 Stunden auf 80°C erhitzt. Mari erhielt eine Suspension des Natriumsalzes der Azobarbitursäure; zusätzlich waren noch ca. 22 g des als Nebenprodukt entstandenen Benzolsulfonamids gelöst vorhanden.

Eine so hergestellte Suspension wurde auf 95°C bis 100°C aufgeheizt, genutscht und mit ca. 1 1 siedend heißem Wasser in mehreren Portionen gewaschen. Man erhielt einen Presskuchen des Natriumsalzes der Azobarbitursäure.

Der so hergestellte Presskuchen wurde mit 500 ml Wasser angerührt. Bei 80°C tropfte man in ca. 5 Minuten eine Lösung von 34,5 g $NiCl_2$-$6H_2O$ und 13 wasserfreiem Natriumacetat in 100 ml Wasser hinzu. Die Mischung wurde 1 Stunde gerührt bei 80°C, danach 42 g Melamin zugefügt und nochmals 1 Stunde bei 80°C und 2 Stunden bei 95°C gerührt, anschließend heiß genutscht und mit heißem Wasser gewaschen.

Man erhielt einen wasserfeuchten Pigment-Presskuchen mit einem Trockengehalt von 42,6 Gew.-%.

Die Farbortbestimmung des getrockneten und gemahlenen Pigmentes in einem Alkyd-Melamin-Lacksystem nach DIN 53238 (Normfarbwertanteile x, y (Farbort) und Normfarbwert Y (Hellbezugswert)) ergab:

x = 0,438 y = 0,464 Y = 58,38

**Beispiel 2:**

Herstellung einer Einschlussverbindung des Pigmentes gemäß Formel (Ia), worin Me = Ni, $R^1 = R^{1'}$ = O, R = R' = OH, die Melamin eingelagerten enthält: grünstichig gelbes Pigment

In 810 g dest. Wasser wurden 136 g Aminoguandinbicarbonat eingetragen und mit 280 g Salzsäure ( 30 %ig ) gelöst. Danach wurde die Lösung mit 780 g Eis auf ca. -10°C abgekühlt und anschließend mit 232 g einer 37 %igen Kaliumnitritlösung in Wasser bis ca. 15°C versetzt. Danach wurde die Lösung bei ca. 15°C 15 Min. nachgerührt und anschließend mit 2,0 g Amidoschwefelsäure versetzt. Danach wurden 269 g Barbitursäure eingetragen, anschließend wird auf 55°C erwärmt und 2 Std. nachgerührt. Anschließend wurde mit wässriger Kalilauge auf pH 2,5 eingestellt und 30 Min. nachgerührt. Danach wurde mit wässriger Kalilauge auf pH 4,8 eingestellt und 30 Min. nachgerührt. Anschließend wurde der Ansatz auf 80°C erwärmt und 3 Std. bei pH 4,8 nachgerührt. Danach wurde auf einer Saugnutsche isoliert, elektrolytfrei gewaschen, bei 40°C im Umlufttrockenschrank getrocknet und gemahlen. Man erhielt 334 g eines orangenroten Pulvers.

| | | | | |
|---|---|---|---|---|
| Berechnung für Monokaliumsalz x 1 $H_2O$ | C 28,4 | H 2,1 | N 24,8 | K 11,6 |
| Gefunden | C 27,8 | H 2,4 | N 24,3 | K 12,0 |

Die Differential Scanning Calorimetry (DSC) ist eine spezielle Form der Differentialthermoanalyse. Die DCS-Analysen wurden auf einen Gerät der Firma Mettler in einem Ofen des Typs DSC 20 gemessen. Die Proben wurden im Tiegel mit dreifach gelochtem Deckel bei einer Aufheizrate von 10 K/Minute untersucht.

Unter den genannten Bedingungen zeigte die nach der obigen Vorschrift hergestellte Verbindung ein endothermes Signal bei 135°C. (Die genannte Temperatur von 135°C kann , bedingt durch die Reproduzierbarkeitsgrenzen der DSC-Methode um ± 10°C schwanken.) Aus der Differentialthermoanalyse in Verbindung mit Fourier-Transform-IR-Analyse folgt, dass bei der genannten Temperatur ein Moläquivalent Wasser abgegeben wurde.

425 g wasserfeuchte Paste der nach Beispiel 1 aus DE-A 19 945 245 hergestellten α-Modifikation des Azobarbitursäure Monokaliumsalz *H2O mit einem Trockengehalt von 40 %, entsprechend 170 g trocken, wurden in 5 000 ml destilliertem Wasser mit einem Laborrührer homogen verrührt, auf 95°C erwärmt mit 126 g Melamin versetzt. Anschließend wurden 1 060 g wässrige 6,5 %ige Nickelchloridlösung zugesetzt und 1,5 Std. bei 95°C nachgerührt. Danach wurde mit Kalilauge auf pH 5,5 gestellt. Anschließend wurde auf einer Saugnutsche isoliert, elektrolytfrei gewaschen, bei 80°C im Vakuumtrockenschrank getrocknet und gemahlen. Man erhält 288 g eines grünlichen gelben Pulvers.

Die Farbortbestimmung des getrockneten und gemahlenen Pigmentes in einem Alkyd-Melamin-Lacksystem nach DIN 53238 (Normfarbwertanteile x, y (Farbort) und Normfarbwert Y (Hellbezugswert)) ergab:

x = 0,435 y = 0,467 Y = 60,71

**Beispiel 3:**

Herstellung einer festen Pigmentpräparation enthaltend eine Einschlussverbindung des Pigmentes gemäß Beispiel 1.

8,3 kg eines gemäß Beispiel 1 hergestellten Presskuchens wurden in 25 kg Wasser homogen angeschlagen. 32,5 kg dieser Suspension wurden mit 19,1 kg Wasser versetzt, auf ca. 70°C aufgeheizt, mit verdünnter Natronlauge auf pH 8,8 gestellt und ca. 30 Minuten gerührt.

Anschließend wurden 9,4 kg einer ca. 70°C heißen, mittels Natronlauge auf pH 8,8 eingestellten wässrigen Lösung enthaltend 5 Gew.-% eines Block-Copolymeren auf Basis von (Poly)Hydroxy Fettsäure und Polyalkylenglykol und 2,0 Gew.-% eines oberflächenaktiven Mittels auf Basis eines Esters eines Alkoxylierungsproduktes gemäß Formel (XI), hergestellt wie in Beispiel 10 von DE-A 19 801 759 beschrieben zugegeben, und 30 Minuten bei 70°C gerührt. Danach wurde der pH Wert unter Rühren und Temperaturhalten mit Salzsäure auf ca. 2 eingestellt, ca. 60 Minuten nachgerührt, mittels Natronlauge auf pH 5,2 eingestellt und 30 Minuten bei ca. 70°C nachgerührt.

Die so erhaltene Suspension wurde auf 35°C abgekühlt, abgesaugt und mit 30°C warmen Wasser solange gewaschen, bis eine Leitfähigkeit von weniger als 600 µSi/cm erreicht wurde.

Man erhielt einen wasserfeuchten Pigment-Presskuchen mit einem Trockengehalt von 39 Gew.-%. Dieser Preßkuchen wurde bei 70°C auf eine Restfeuchte von weniger als 1 Gew.-% ofengetrocknet und mittels Messermühle

zur erfindungsgemäß zu verwendenden festen Pigmentpräparation feingemahlen.

Die Farbortbestimmung des getrockneten und gemahlenen Pigmentes in einem Alkyd-Melamin-Lacksystem nach DIN 53238 (Normfarbwertanteile x, y (Farbort) sowie den Normfarbwert Y (Hellbezugswert)) ergab:

$$x = 0{,}442 \qquad y = 0{,}465 \qquad Y = 57{,}52$$

<u>**Verwendungsbeispiel 1**</u>

Herstellung einer gelben Zubereitung und Verwendung zur Herstellung eines gelben Farbfilters:

In einem Rührbehälter wurden

| | |
|---|---|
| 774 Gew.Teile | Methoxybutylacetat (Butoxyl® , Hoechst AG) und |
| 286 Gew.Teile | einer 21 % igen Lösung eines alkalisch löslichen Copolymeren (Bindemittelharz) auf Basis von Benzylmethacrylat (70T) / 2-Hydroxyethylmethacrylat (15T) / Methacrylsäure (15T), Mol.Gew. ca. 25 000 g/mol, in Methoxypropylacetat homogen gemischt und anschließend |
| 100 Gew.Teile | der Einschlussverbindung des Pigmentes gemäß Beispiel 1, dass zuvor bei ca. 70°C auf eine Restfeuchte von weniger als 1 Gew.-% getrocknet wurde, homogen eingetragen. |

Diese Pigmentsuspension wurde in einer horizontalen, geschlossenen Perlmühle unter Einsatz von Yttriumstabilisierten Zirkonoxidperlen (Durchmesser 0,6 bis 1,0 mm) in mehreren Passagen gemahlen, bis ein effektiver Partikeldurchmesser (gemessen mit Laserstreulichkorrelationsspektroskopie an einer ca. 0,5 Gew.-% Verdünnung in Methoxypropylacetat) von weniger als 150 nm verbunden mit einer Polydispersität von weniger als 0,14 erreicht war. (Vergleichsweise konnte elektronenmikroskopisch an einem getrockneten Film aus einer 1 %igen Verdünnung in Methoxypropylacetat) eine sehr enge Partikelgrößenverteilung mit 95 % Anzahl der Teilchen unter 100 nm festgestellt werden.)

Die erhaltene Zubereitung zeigte eine ausreichende Lagerstabilität und war zur Herstellung eines Photolackes für Farbfilter nach der Pigment-Dispersionsmethode gut geeignet.

Herstellung eines Photolacks

Zu

| | |
|---|---|
| 1000 Gew.Teilen | der so erhaltene Zubereitung wurden |
| 34,5 Gew.Teile | Trimethylolpropantriacrylat (monomerer Reaktivverdünner) und |
| 13,8 Gew.Teile | eines Photoreaktionsstarters auf Basis von Benzophenon und N,N'-Tetraethyl-4,4'-diaminobenzophenon im Verhältnis von 3/1 Gew.Teilen unter Rühren homogen eingetragen. |

Man erhielt einen UV- strahlungshärtbaren Photolack, der auf einem transparenten Substrat aufgetragen und zum Farbfilter entwickelt wurde.

Hierzu wurde der Photolack mittels Spin-Coating auf ein 300 350 mm großes Stück gereinigten Borosilikatglases (Corning® 7059, **Owens Corning Corp.**) beschichtet und bei 110°C 5 Minuten in einem Ofen unter Reinbedingungen zu einem ca. 1,5 bis 2 μm dicken Film getrocknet.

Anschließend wurde der Film nach Abkühlung mittels einer Negativmaske zur Erzielung des gewünschten Streifen-Bildmusters und einer Ultrahochdruck-Quecksilberdampflampe bei einer Dosis von 200 mJ/cm$^2$ UV-belichtet und dann mittels 0,06 %iger wässriger Kaliumhydroxidlösung bei Raumtemperatur entwickelt, mit vollentsalztem Wasser gereinigt und getrocknet. Abschließend erfolgte eine 30 minutige Nachhärtung bei 235°C in einem Ofen unter Reinbedingungen.

Der so erhaltene gelbe, gestreifte Farbfilter besaß sehr gute spektrale Transparenzeigenschaften und eine hohe Farbreinheit und Brillanz.

Von besonderem Interesse für die Eignung als Farbfilter in LCD ist die Licht- und Hitzebeständigkeit der eingesetzten Farbpigmente.

Zur Prüfung der Temperaturbeständigkeit wurden Farbfilter wie oben hergestellt und 1 Stunde lang bei 250°C in einem Ofen gelagert. Die Gesamtrestfarbabweichung ΔE mittels Cielab Messung im Vergleich zu einem nicht thermisch behandelten Film ergab ein ΔE von 0,7.

Zur Prüfung der Lichtechtheit wurden 0,7 g der oben beschriebenen gemahlenen Zusammensetzung (ohne monomere Reaktivverdünner und Photoreaktionsstarter) in 10 g eines klaren Prüflackes auf Collodium-Basis (Isoderm® Glanz TS, Bayer AG) homogen verteilt und auf weißem Lackprüfkarton sowie transparenter Folie (HP Premium® Ink Jet, Fa. Hewlett Packard) aufgezogen und getrocknet.

Anschließend erfolgte 500 Stunden eine Belichtung nach DIN EN 105B02. Die Gesamtrestfarbabweichung ΔE mittels Cielab Messung im Vergleich zum unbelichteten Aufstrich ergab:

| | |
|---|---|
| weißer Lackprüfkarton | ΔE = 18,7 |
| transparente Folie | ΔE = 10,5 |

**Verwendungsbeispiel 2**

Herstellung einer gelben Zubereitung und Verwendung zur Herstellung eines gelben Farbfilters:

Mit dem gleichen Verfahren wie in Verwendungsbeispiel 1 beschrieben jedoch unter Einsatz der getrockneten Einschlussverbindung hergestellt nach Beispiel 2) wurde eine Zubereitung mit vergleichbar guter Feinverteilung und Langzeitlagerstabilität hergestellt, die in der Anwendung in einem Photolack für Farbfilter ebenso gute Eigenschaften, insbesondere Licht- und Temperaturbeständigkeit zeigte.

Die Lichtechtheitsbeurteilung wurde wie in Verwendungsbeispiel 1 beschrieben durchgeführt.

Die Gesamtrestfarbabweichung ΔE mittels Cielab Messung im Vergleich zum unbelichteten Aufstrich ergab:

| | |
|---|---|
| weißer Lackprüfkarton | ΔE = 10,1 |
| transparente Folie | ΔE = 8,3 |

**Verwendungsbeispiel 3**

Herstellung einer gelben Zubereitung und Verwendung zur Herstellung eines gelben Farbfilters:

Mit dem gleichen Verfahren wie in Verwendungsbeispiel 1 beschrieben jedoch unter Einsatz der festen Pigmentpräparation aus Beispiel 3 (an Stelle der getrockneten bevorzugten Einschlussverbindung hergestellt nach Beispiel 1) wurde eine Zubereitung mit sehr guter Feinverteilung und Langzeitlagerstabilität hergestellt, die in der Anwendung in einem Photolack für Farbfilter ebenso gute Eigenschaften, insbesondere Licht- und Temperaturbeständigkeit zeigte.

**Verwendungsbeispiel 4**

Herstellung einer grünen Zubereitung und Verwendung zur Herstellung eines grünen Farbfilters:

Mit dem gleichen Verfahren wie in Verwendungsbeispiel 1 beschrieben jedoch unter Einsatz von

| | |
|---|---|
| 40 Gew.Teilen | der Einschlussverbindung des Pigmentes gemäß Beispiel 2, und |
| 60 Gew.Teile | des grünen organischen Pigmentes Heliogen® Grün L 9361 (Pigment Green 36, BASF AG) |

anstelle von 100 Gew.Teilen des getrockneten Pigmentes hergestellt nach Beispiel 1 wurde eine Zubereitung mit hoher Feinverteilung und ausreichender Langzeitlagerstabilität hergestellt, die zur Herstellung grüner Photolacke für Farbfilter sehr gut geeignet war.

Ein wie in Verwendungsbeispiel 1 beschrieben hergestellter Photolack und damit hergestellter grüner, gestreifter Farbfilter besaß sehr gute spektrale Transparenzeigenschaften sowie ausgezeichnete Farbreinheit und Brillanz sowie eine sehr gute Lichtechtheit.

**Verwendungsbeispiel 5**

Herstellung einer Einschlussverbindung des Pigmentes der Formel (Ia), worin Me = Zn, $R^1 = R^{1'}$ = O; R = OH, R' = NHCN, die ein Block-Copolymer eingelagert enthält: oranges Pigment

Herstellung des Ausgangsproduktes Cyaniminoazobarbitursäure:

4,9 Mol Diazobarbitursäure (755 g) und 5,0 Mol Cyaniminobarbitursäure werden in 10 l $H_2O$ angeschlagen und auf 80°C erhitzt. Der pH wird nach Erreichen von 80°C mit 30 % NaOH auf 5 gestellt und es wird 3 Stunden gerührt. Das rote Produkt wird filtriert und mit heißem Wasser (101) nachgewaschen und auf einen Restfeuchtegehalt von weniger als 1 Gew.-% getrocknet.

0,3 Mol dieses Produktes werden in 2 1 deionisiertem Wasser angeschlagen und 0,31 Mol $ZnCl_2$ zugesetzt.

Die Suspension wird 3 Stunden bei 95 °C und pH 5 gerührt. In 500 ml Wasser werden 40 g eines auf Ethylendiamin gestarteten Ethylenoxid-Propylenoxid-Block-Copolymeren mit einem Molekulargewicht von ca. 6700 (Tetronic® T 904, BASF AG) angeschlagen und auf 50°C erwärmt. Diese Lösung wird mit obiger Suspension vereint und weitere 2 Stunden bei 95°C gerührt.

Anschließend wird der Ansatz abfiltriert, mit 2 1 heißem Wasser gewaschen, 12 Stunden im Vakuum getrocknet und in einer Labormühle trocken gemahlen. Das so erhaltene Pigmentpulver wird nach DIN 53238 in einem Alkyd-Melamin-Lacksystem dispergiert.

Die Farbortbestimmung ergab:

$$x = 0{,}561 \qquad y = 0{,}365 \qquad Y = 26{,}05$$

Mit dem gleichen Verfahren wie in Verwendungsbeispiel 1 beschrieben ließ sich eine stabile Zubereitung mit hoher Feinverteilung und ausreichender Langzeitlagerstabilität herstellen, die zur Herstellung von Photolacken für Farbfilter sehr gut geeignet war. Insbesondere eignete sich das Pigment zur Einstellung gewünschter roter Farbfilter in Kombination mit anderen Rot- u/o Gelbpigmenten wie beispielsweise hergestellt nach den Beispielen 1 bis 3.

## Verwendungsbeispiel 6

Herstellung einer Einschlussverbindung des Pigmentes der Formel (Ia), worin Me = Zn, $R^1 = R^{1'} = O$; R = OH, R' = NHCN, die Melamin eingelagert enthält: oranges Pigment

0,3 Mol der in Beispiel 5 hergestellten Cyaniminoazobarbitursäure werden in 2 1 deionisiertem Wasser angeschlagen und 0,31 Mol $ZnCl_2$ zugesetzt. Die Suspension wird 3 Stunden bei 95°C und pH 5 gerührt.

In 500 ml Wasser werden 0,6 Mol Melamin angeschlagen und auf 50°C erwärmt. Diese Lösung wird mit obiger Suspension vereint und weitere 2 Stunden bei 95°C gerührt. Anschließend wird der Ansatz abfiltriert, mit 2 l heißem Wasser gewaschen, 12 Stunden im Vakuum getrocknet und in einer Labormühle trocken gemahlen. Das so erhaltene Pigmentpulver wird nach DIN 53238 in einem Alkyd-Melamin-Lacksystem dispergiert.

Die Farbortbestimmung ergab:

$$x = 0{,}558 \qquad y = 0{,}358 \qquad Y = 21{,}2$$

Mit dem gleichen Verfahren wie in Verwendungsbeispiel 1 beschrieben ließ sich eine stabile Zubereitung mit hoher Feinverteilung und ausreichender Langzeitlagerstabilität herstellen, die zur Herstellung von Photolacken für Farbfilter sehr gut geeignet war. Insbesondere eignete sich das Pigment zur Einstellung gewünschter roter Farbfilter in Kombination mit anderen Rot- u/o Gelbpigmenten wie beispielsweise hergestellt nach den Beispielen 1 bis 3.

## Verwendungsbeispiel 7

Herstellung einer Einschlussverbindung des Pigmentes der Formel (Ia), worin Me = La, $R^1 = R^{1'} = O$; R = OH, R' = NHCN, die Melamin eingelagert enthält: orangesrotes Pigment

0,3 Mol der in Beispiel 5 hergestellten Cyaniminoazobarbitursäure werden in 2 l deionisiertem Wasser angeschlagen und 0,3 Mol $La(NO_3)_3$ zugesetzt. Die Suspension wird_3 Stunden bei 95°C und pH 5 gerührt.

In 500 ml Wasser werden 0,6 Mol Melamin angeschlagen und auf 50°C erwärmt. Diese Lösung wird mit obiger Suspension vereint und weitere 2 Stunden bei 95°C gerührt. Anschließend wird der Ansatz abfiltriert, mit 2 1 heißem Wasser gewaschen, 12 Stunden im Vakuum getrocknet und in einer Labormühle trocken gemahlen. Das so erhaltene Pigmentpulver wird nach DIN 53238 in einem Alkyd-Melamin-Lacksystem dispergiert.

Die Farbortbestimmung ergab:

$$x = 0{,}540 \qquad y = 0{,}344 \qquad Y = 16{,}6$$

Mit dem gleichen Verfahren wie in Verwendungsbeispiel 1 beschrieben ließ sich eine stabile Zubereitung mit hoher Feinverteilung und ausreichender Langzeitlagerstabilität herstellen, die zur Herstellung von Photolacken für Farbfilter sehr gut geeignet war. Insbesondere eignete sich das Pigment zur Einstellung gewünschter roter Farbfilter in Kombination mit anderen Rot- und/oder Gelbpigmenten wie beispielsweise hergestellt nach den Beispielen 1 bis 3.

## Verwendungsbeispiel 8

Herstellung einer Einschlussverbindung des Pigmentes der Formel (Ia), worin Me = Ba, $R^1 = R^{1'}$ = O; R = OH, R' = NHCN, die Polyvinylpyrrolidin eingelagert enthält: rotes Pigment

0,3 Mol der in Beispiel 5 hergestellten Cyaniminoazobarbitursäure werden in 2 1 deionisiertem Wasser angeschlagen und 0,3 Mol $BaCl_2$ zugesetzt. Die Suspension wird 3 Stunden bei 95°C und pH 5 gerührt.

In 500 ml Wasser werden 40 g Polyvinylpyrrolidon (MW 30 000 g/mol) angeschlagen und auf 50°C erwärmt. Diese Lösung wird mit obiger Suspension vereint und weitere 2 Stunden bei 95°C gerührt. Anschließend wird der Ansatz abfiltriert, mit 2 l heißem Wasser gewaschen, 12 Stunden im Vakuum getrocknet und in einer Labormühle trocken gemahlen. Das so erhaltene Pigmentpulver wird nach DIN 53238 in einem Alkyd-Melamin-Lacksystem dispergiert.

Die Farbortbestimmung ergab:

x = 0,493 y = 0,334 Y = 11,4

Mit dem gleichen Verfahren wie in Verwendungsbeispiel 1 beschrieben ließ sich eine stabile Zubereitung mit hoher Feinverteilung und guter Langzeitlagerstabilität herstellen, die zur Herstellung von Photolacken für Farbfilter sehr gut geeignet war. Insbesondere eignete sich das Pigment zur Einstellung gewünschter roter Farbfilter in Kombination mit anderen Rot- und/oder Gelbpigmenten wie beispielsweise hergestellt nach den Beispielen 1 bis 4.

## Verwendungsbeispiel 9

Herstellung einer Einschlussverbindung des Pigmentes der Formel (Ia), worin Me = Ca, $R^1 = R^{1'}$ = O; R = OH, R' = NHCN, die ein Block-Copolymer eingelagert enthält: rot-oranges Pigment

0,3 Mol der in Beispiel 5 hergestellten Cyaniminoazobarbitursäure werden in 2 1 deionisiertem Wasser angeschlagen und 0,3 Mol $CaCl_2$ 2 $H_2O$ zugesetzt. Die Suspension wird 3 Stunden bei 95°C und pH 5 gerührt.

In 500 ml Wasser werden 40 g eines auf Ethylendiamin gestarteten Ethylenoxid-Propylenoxid-Block-Copolymeren mit einem Molekulargewicht von ca. 1650 (Tetronic® T 304, BASF AG) angeschlagen und auf 50°C erwärmt. Diese Lösung wird mit obiger Suspension vereint und weitere 2 Stunden bei 95°C gerührt. Anschließend wird der Ansatz abfiltriert, mit 2 1 heißem Wasser gewaschen, 12 Stunden im Vakuum getrocknet und in einer Labormühle trocken gemahlen. Das so erhaltene Pigmentpulver wird nach DIN 53 238 in einem Alkyd-Melamin-Lacksystem dispergiert.

Die Farbortbestimmung ergab:

x = 0,541 y = 0,353 Y = 27,63

Mit dem gleichen Verfahren wie in Verwendungsbeispiel 1 beschrieben ließ sich eine stabile Zubereitung mit hoher Feinverteilung und ausreichender Langzeitlagerstabilität herstellen, die zur Herstellung von Photolacken für Farbfilter sehr gut geeignet war. Insbesondere eignete sich das Pigment zur Einstellung gewünschter roter Farbfilter in Kombination mit anderen Rot- und/oder Gelbpigmenten wie beispielsweise hergestellt nach den Beispielen 1 bis 4.

## Patentansprüche

1. Verwendung von Metallkomplexen einer Azo-Verbindung, die der Formel (I) oder einer ihrer tautomeren Strukturen entspricht

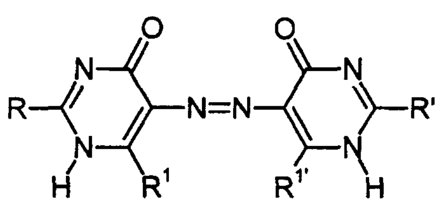

(I)

worin

R und R' unabhängig voneinander für OH, $NH_2$, NH-CN, Acylamino oder Arylamino stehen und

$R^1$ und $R^{1'}$ unabhängig voneinander -OH oder $-NH_2$ bedeuten,

und die wenigstens eine Verbindung eingelagert enthält, wobei die Metallkomplexe den Mono, Di-, Tri- und Tetraanionen der Azo-Verbindungen der Formel (I) mit den Metallen Li, Cs, Mg, Cd, Co, Al, Cr, Sn, Pb, besonders bevorzugt Na, K, Ca, Sr, Ba, Zn, Fe, Ni, Cu, Mn und La entsprechen als Pigment in Farbfiltern für Flüssigkristallanzeigen .

2. Verwendung gemäß Anspruch 1, **dadurch gekennzeichnet, dass** die Azo-Verbindung der Formel (I) der Formel (II) oder einer tautomeren Form davon entspricht

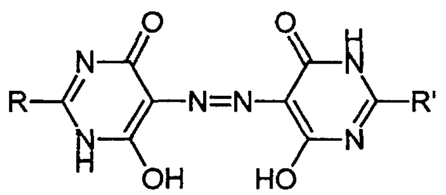

(II),

in der

R und R' unabhängig voneinander OH und NHCN bedeuten.

3. Verwendung von Metallkomplexen gemäß Anspruch 1, **dadurch gekennzeichnet, dass** die eingelagerte Verbindung eine cyclische oder acyclische organische Verbindung ist, insbesondere Melamin oder Melaminderivate oder Polykondensate, bevorzugt solche auf Basis von Harnstoff und Formaldehyd sowie Block-Copolymerisate auf Basis von (Poly)Stearinsäure, (Poly)ethylenund/oder (Poly)propylenoxid.

4. Verwendung von Metallkomplexen gemäß Anspruch 1, **dadurch gekennzeichnet, dass** es sich um die 1:1 Azo-Metall-Komplexe, die der Formel (Ia) oder einer ihrer tautomeren Formen entsprechen, handelt

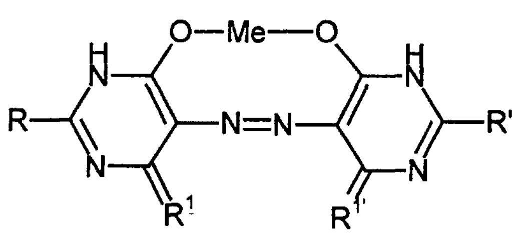

(Ia)

worin

Me die in Anspruch 1 genannten Metalle bedeutet,

R und R' und $R^1$ und $R^{1'}$ die in Anspruch 1 angegebenen Bedeutungen besitzen.

5. Verwendung von Metallkomplexen gemäß Anspruch 1, **dadurch gekennzeichnet, dass** ihr Farbort durch folgende Normfarbwertanteile x und y definiert wird:

x = 0,38 bis 0,72
y = 0,14 bis 0,55.

6. Verwendung von Einschlussverbindungen, Interkalationsverbindungen und feste Lösungen gemäß Anspruch 1,

bei denen der Azobarbitursäure-Nickel-1:1-Komplex eine der tautomeren Formen der Formel (IIa) entspricht und mindestens eine andere Verbindung der Formel (III) eingeschlossen enthält.

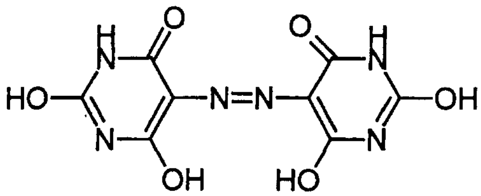

(IIa)

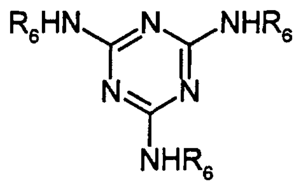

(III)

worin

$R_6$ für Wasserstoff oder $C_1$-$C_4$-Alkyl, das gegebenenfalls mit OH-Gruppen substituiert ist, steht,

**7.** Verwendung gemäß Anspruch 1, **dadurch gekennzeichnet, dass** die Azo-Verbindung den Mono- oder Dikaliumsalzen der Formel (I, II, IIa, IIb, IIc) oder einer ihrer tautomeren Strukturen oder seiner Hydrate entspricht.

**8.** Verwendung gemäß Anspruch 1, **dadurch gekennzeichnet, dass** die Azo-Verbindung dem Mono- oder Dikaliumsalz der Azobarbitursäure der Formel (IIa) entspricht.

**9.** Pigmentpräparationen, enthaltend

a) wenigstens einen Metallkomplex einer Azo-Verbindung, die der Formel (I) oder einer ihrer tautomeren Strukturen entspricht

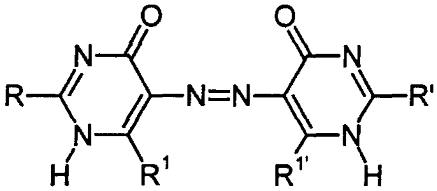

(I)

worin

R und R' unabhängig voneinander für OH, $NH_2$, NH-CN, Acylamino oder Arylamino stehen und

$R^1$ und $R^{1'}$ unabhängig voneinander -OH oder -$NH_2$ bedeuten,

wobei die Metallkomplexe wenigstens eine Verbindung eingelagert enthalten, und den Mono, Di-, Tri- und Tetraanionen der Azo-Verbindungen der Formel (I) mit den Metallen ausgewählt aus der folgenden Gruppe Li, Cs, Mg, Cd, Co, Al, Cr, Sn, Pb, besonders bevorzugt Na, K, Ca, Sr, Ba, Zn, Fe, Ni, Cu, Mn und La entsprechen,

b) wenigstens eine organische Verbindung ausgewählt aus der Gruppe der Terpene, Terpenoide, Fettsäureester und der Gruppe der Homooder Copolymere, wie statistische- oder Block-Copolymere mit einer Löslichkeit in Wasser bei 20°C von weniger als 1 g/l, insbesondere weniger als 0,1 g/l.

**10.** Pigmentpräparation gemäß Anspruch 9, enthaltend zusätzlich bezogen auf die Komp. a) 1 bis 100 Gew.-%, insbesondere 0,5 bis 60 Gew.%, mindestens eines oberflächenaktiven Mittels das der Formel (X) oder Formel (XI) entspricht.

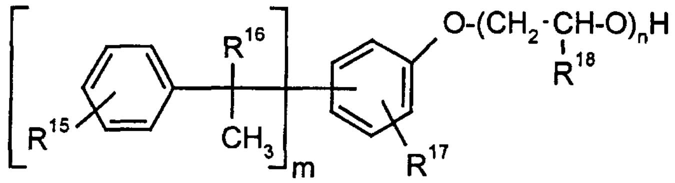

(X),

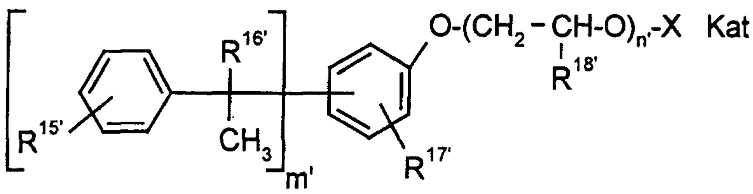

(XI)

in denen

$R^{15}$ Wasserstoff oder $C_1$-$C_4$-Alkyl bedeutet,

$R^{16}$ für Wasserstoff oder $CH_3$ steht,

$R^{17}$ Wasserstoff, $C_1$-$C_4$-Alkyl, $C_1$-$C_4$-Alkoxy, $C_1$-$C_4$-Alkoxycarbonyl oder Phenyl bedeutet,

m eine Zahl von 1 bis 4 bedeutet,

n eine Zahl von 6 bis 120 bedeutet,

$R^{18}$ für jede durch n indizierte Einheit gleich oder verschieden ist und für Wasserstoff, $CH_3$ oder Phenyl steht, wobei im Falle der Mitanwesenheit von $CH_3$ in den verschiedenen -(-$CH_2$-CH($R^{18}$)-O-)-Gruppen in 0 bis 60 % des Gesamtwertes von n $R^{18}$ für $CH_3$ und in 100 bis 40 % des Gesamtwertes von n $R^{18}$ für Wasserstoff steht und wobei im Falle der Mitanwesenheit von Phenyl in den verschiedenen -(-$CH_2$-CH($R^{18}$)-O-)-Gruppen in 0 bis 40 % des Gesamtwertes von n $R^{18}$ für Phenyl und in 100 bis 60 % des Gesamtwertes von n $R^{18}$ für Wasserstoff steht.

und

$R^{15'}$, $R^{16'}$, $R^{17'}$, $R^{18'}$, m' und n' den Bedeutungsumfang von $R^{15}$, $R^{16}$, $R^{17}$, $R^{18}$, m bzw. n, jedoch unabhängig hiervon, annehmen,

X die Gruppe -$SO_3$, -$SO_2$, -$PO_3$ oder -CO-($R^{19}$)-COO bedeutet,

Kat ein Kation aus der Gruppe von H, Li, Na, K, $NH_4$ oder HO-$CH_2CH_2$-$NH_3$ ist, wobei im Falle von X = -$PO_3$ zwei Kat vorliegen und

$R^{19}$ für einen zweiwertigen aliphatischen oder aromatischen Rest steht, vorzugsweise für $C_1$-$C_4$-Alkylen, insbesondere Ethylen, $C_2$-$C_4$-einfach ungesättigte Reste, insbesondere Acetylen oder gegebenenfalls substituiertes Phenylen, insbesondere ortho-Phenylen steht, wobei als mögliche Substituenten vorzugsweise $C_1$-$C_4$-Alkyl, $C_1$-$C_4$-Alkoxy, $C_1$-$C_4$-Alkoxycarbonyl oder Phenyl in Frage kommen.

**11.** Pigmentpräparationen gemäß Anspruch 9, **dadurch gekennzeichnet, dass** die Azo-Verbindung der Formel (I) der Formel (II) oder einer tautomeren Form davon entspricht

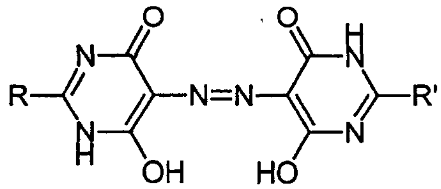 (II),

in der

R und R' unabhängig voneinander OH und NHCN bedeuten,

wobei die eingelagerte Verbindung eine cyclische oder acyclisch organische Verbindung ist, insbesondere Melamin oder Melaminderivate oder Polykondensate, bevorzugt solche auf Basis von Harnstoff und Formaldehyd sowie Block-Copolymerisate auf Basis von (Poly)Stearinsäure, (Poly)ethylenund/oder (Poly)propylenoxid.

**12.** Pigmentpräparationen gemäß Anspruch 9, **dadurch gekennzeichnet, dass** es sich bei den Pigmenten (a) um die 1:1 Azo-Metall-Komplexe, die der Formel (Ia) oder einer ihrer tautomeren Formen entsprechen, handelt

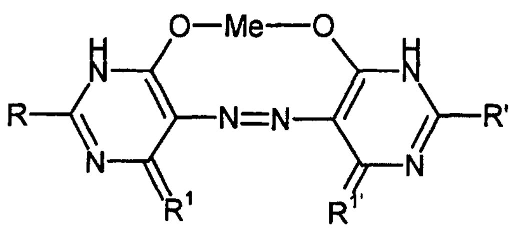 (Ia)

worin

Me die in Anspruch 1 genannten Metalle bedeutet,

R und R' und $R^1$ und $R^{1'}$ die in Anspruch 1 angegebenen Bedeutungen besitzen.

**13.** Pigmentpräparationen gemäß Anspruch 9, **dadurch gekennzeichnet, dass** die Pigmente (a) Einschlussverbindungen, Interkalationsverbindungen und feste Lösungen sind, bei denen der Azobarbitursäure-Nickel-1:1-Komplex eine der tautomeren Formen der Formel (IIa) entspricht und mindestens eine andere Verbindung der Formel (III) eingeschlossen enthält,

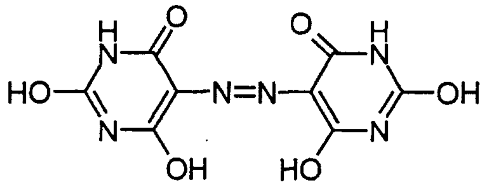

(IIa)

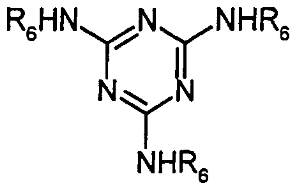

(III)

worin

$R_6$ für Wasserstoff oder $C_1$-$C_4$-Alkyl, das gegebenenfalls mit OH-Gruppen substituiert ist, steht,

**14.** Verwendung von Pigmentpräparationen gemäß Anspruch 9 zur Herstellung von Farbfiltern für Flüssigkristallanzeigen.

**15.** Photolack, enthaltend wenigstens ein photohärtbares Monomer wenigstens einen Photoinitiator und wenigstens ein Metallkomplex einer Azo-Verbindung der Formel (I) gemäß Anspruch 1, die wenigstens eine weitere Verbindung eingelagert enthält.

**16.** Verfahren zur Herstellung von Farbfiltern für Flüssigkristallanzeigen, **dadurch gekennzeichnet, dass** wenigstens ein Metallkomplexe einer Azo-Verbindung der Formel I, gemäß Anspruch 1, die wenigstens eine weitere Verbindung eingelagert enthält, in einem organischen Lösungsmittel gegebenenfalls unter Zusatz eines Bindemittelharzes und/oder Dispergiermittels gemahlen wird, anschließend unter Zusatz von photohärtbaren Monomeren, Photoreaktionsstarter und ggf. weiterem Bindemittel und/oder Lösungsmittel zu einem Photolack verarbeitet wird, der im Anschluss daran mittels geeigneter Beschichtungsverfahren wie z.B. Roller-, Spray-, Spin-, Dip- oder Air-Knife-Coating auf ein geeignetes Substrat, im Allgemeinen Glasplatte aufgetragen wird, mittels Photomaske belichtet und anschließend gehärtet und zum fertigen farbigen Farbfilter entwickelt wird.

**17.** Farbfilter enthaltend wenigstens einen Metallkomplex einer Azo-Verbindung der Formel (I) gemäß Anspruch 1, die wenigstens eine weitere Verbindung eingelagert enthält.

**18.** Flüssigkristallanzeige, enthaltend wenigstens einen Farbfilter gemäß Anspruch 17.

**19.** Verwendung von Metallkomplexen von Azo-Verbindungen der Formel I gemäß Anspruch 1, die wenigstens eine andere Verbindung eingelagert enthalten, in Drucktinten zur Herstellung von Farbfiltern nach dem Verfahren der Photolithographie, Offset-Druck oder dem Verfahren des mechanischen, piezzo-mechanischen oder thermischen Ink Jet Drucks.

**20.** Verwendung gemäß Anspruch 19 **dadurch gekennzeichnet, dass** die Drucktinten zusätzlich ein wässrig-organisches Trägermedium enthalten.

## Claims

**1.** Use of metal complexes of an azo compound which conforms to the formula (I) or to one of its tautomeric structures

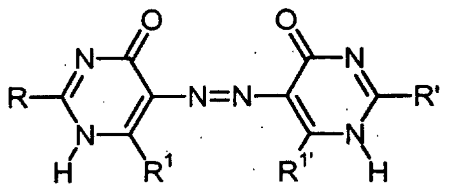

(I)

where

R and R' are independently OH, $NH_2$, NH-CN, acylamino or arylamino and

$R^1$ and $R^{1'}$ are independently -OH or $-NH_2$,

and which hosts at least one guest compound, the metal complexes corresponding to the mono-, di-, tri- and tetraanions of the azo compounds of the formula (I) with the metals Li, Cs, Mg, Cd, Co, Al, Cr, Sn, Pb, particularly preferably Na, K, Ca, Sr, Ba, Zn, Fe, Ni, Cu, Mn and La, as a pigment in colour filters for liquid-crystal displays.

2. Use according to Claim 1, **characterized in that** the azo compound of the formula (I) conforms to the formula (II) or a tautomeric form thereof

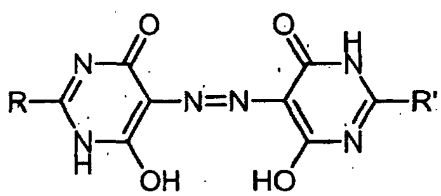

(II),

where

R and R' are independently selected from the group consisting of OH and NHCN.

3. Use of metal complexes according to Claim 1, **characterized in that** the guest compound is a cyclic or acyclic organic compound, especially melamine or melamine derivatives or polycondensates, preferably those based on urea and formaldehyde and also block copolymers based on (poly)stearic acid, (poly)ethylene oxide and/or (poly) propylene oxide.

4. Use of metal complexes according to Claim 1, **characterized in that** they are 1:1 azo metal complexes which conform to the formula (Ia) or one of its tautomeric forms

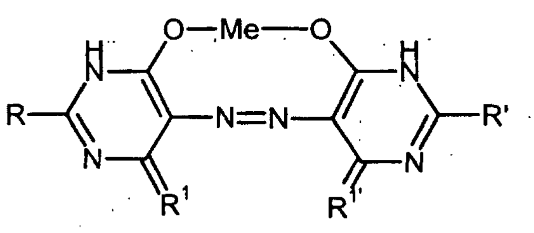

(Ia)

where

Me is a metal as defined in Claim 1 and

R and R' and $R^1$ and $R^{1'}$ are each as defined in Claim 1.

**5.** Use of metal complexes according to Claim 1, **characterized in that** their colour locus is defined by the following chromaticity coordinates x and y:

x = 0.38 to 0.72
y = 0.14 to 0.55.

**6.** Use of inclusion compounds, intercalation compounds and solid solutions according to Claim 1 where the azobarbituric acid-nickel 1:1 complex corresponds to one of the tautomeric forms of the formula (IIa) and includes at least one other compound of the formula (III)

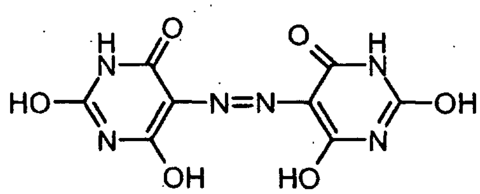

(IIa)

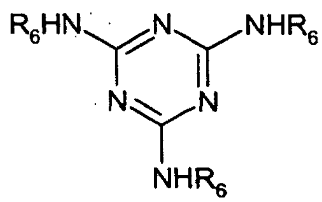

(III)

where

$R_6$ is hydrogen or $C_1$-$C_4$-alkyl which is optionally substituted by OH groups.

**7.** Use according to Claim 1, **characterized in that** the azo compound corresponds to the mono- or dipotassium salts of the formula (I, II, IIa, IIb, IIc) or one of its tautomeric structures or its hydrates.

**8.** Use according to Claim 1, **characterized in that** the azo compound corresponds to the mono- or dipotassium salt of azobarbituric acid of the formula (IIa).

**9.** Pigment preparations containing

a) at least one metal complex of an azo compound which conforms to the formula (I) or one of its tautomeric structures

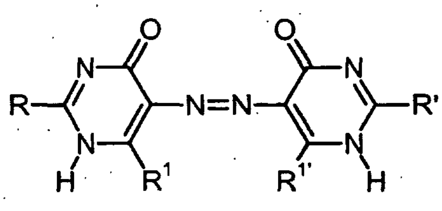

(I)

where

R and R' are independently OH, $NH_2$, NH-CN, acylamino or arylamino and

$R^1$ and $R^{1'}$ are independently -OH or $-NH_2$,

and which hosts at least one guest compound, the metal complexes corresponding to the mono, di-, tri- and tetraanions of the azo compounds of the formula (I) with the metals Li, Cs, Mg, Cd, Co, Al, Cr, Sn, Pb, particularly preferably Na, K, Ca, Sr, Ba, Zn, Fe, Ni, Cu, Mn and La,

b) at least one organic compound selected from the group of the terpenes, terpenoids, fatty acid esters and the group of the homo- or copolymers, such as random or block copolymers, having a 20°C water solubility of less than 1 g/l, especially less than 0.1 g/l.

**10.** Pigment preparation according to Claim 9, containing additionally based on comp. a) 1 to 100% by weight, especially 0.5 to 60% by weight, of at least one surface-active agent which conforms to the formula (X) and/or formula (XI)

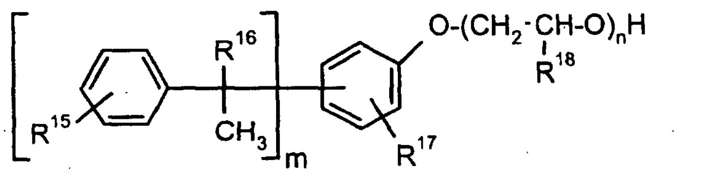

(X),

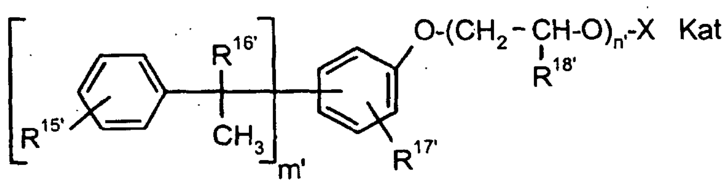

(XI)

where

$R^{15}$ is hydrogen or $C_1$-$C_4$-alkyl,

$R^{16}$ is hydrogen or $CH_3$,

$R^{17}$ is hydrogen, $C_1$-$C_4$-alkyl, $C_1$-$C_4$-alkoxy, $C_1$-$C_4$-alkoxycarbonyl or phenyl,

m is from 1 to 4,

n is from 6 to 120,

$R^{18}$ is identical or different for every unit bearing the index n and represents hydrogen, $CH_3$ or phenyl subject to the proviso that in the case of CH3 being present in the various $-(-CH_2-CH(R^{18})-O-)-$ groups $R^{18}$ is $CH_3$ in 0 to 60% of the total value of n and is hydrogen in 100 to 40% of the total value of n and in the case of phenyl being present in the various $-(-CH_2-CH(R^{18})-O-)-$ groups $R^{18}$ is phenyl in 0 to 40% of the total value of n and hydrogen in 100 to 60% of the total value of n

and

$R^{15'}$, $R^{16'}$, $R^{17'}$, $R^{18'}$, m' and n' assume the scope of meaning of $R^{15}$, $R^{16}$, $R^{17}$, $R^{18}$, m and n, respectively, but independently thereof,

X is $-SO_3$, $-SO_2$, $-PO_3$ or $-CO-(R^{19})-COO$,

Kat is a cation selected from the group consisting of H, Li, Na, K, $NH_4$ and $HO-CH_2CH_2-NH_3$, subject to the proviso that in the case of X = $-PO_3$ two Kat cations are present, and

$R^{19}$ is a divalent aliphatic or aromatic radical, preferably $C_1$-$C_4$-alkylene, especially ethylene, monounsaturated $C_2$-$C_4$ radicals, especially acetylene, or optionally substituted phenylene, especially orthophenylene, preferred possible constituents being $C_1$-$C_4$-alkyl, $C_1$-$C_4$-alkoxy, $C_1$-$C_4$-alkoxycarbonyl or phenyl.

**11.** Pigment preparations according to Claim 9, **characterized in that** the azo compound of the formula (I) conforms to the formula (II) or a tautomeric form thereof

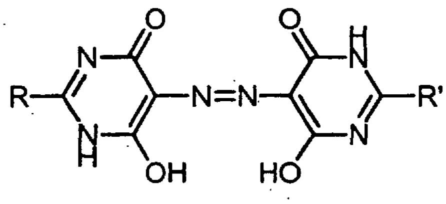

(II),

where

R and R' are independently selected from the group consisting of OH and NHCN,

wherein the included compound is a cyclic or acyclically organic compound, especially melamine or melamine derivatives or polycondensates, preferably those based on urea and formaldehyde and also block copolymers based on (poly)stearic acid, (poly)ethylene oxide and/or (poly)propylene oxide.

**12.** Pigment preparations according to Claim 9, **characterized in that** the pigments (a) are the 1:1 azo metal complexes which conform to the formula (Ia) or one of its tautomeric forms

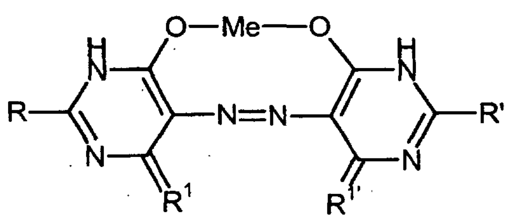

(Ia)

where

Me is a metal as defined in Claim 1, and

R and R' and $R^1$ and $R^{1'}$ are each as defined in Claim 1.

**13.** Pigment preparations according to Claim 9, **characterized in that** the pigments (a) are inclusion compounds, intercalation compounds and solid solutions where the azobarbituric acid-nickel 1:1 complex corresponds to one of the tautomeric forms of the formula (IIa) and includes at least one other compound of the formula (III)

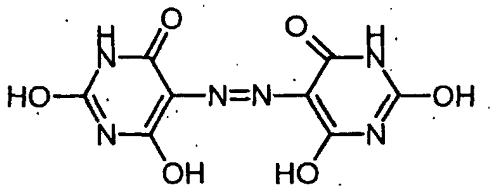

(IIa)

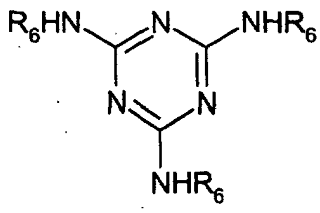

(III)

where

$R_6$ is hydrogen or $C_1$-$C_4$-alkyl which is optionally substituted by OH groups.

**14.** Use of pigment preparations according to Claim 9 for producing colour filters for liquid-crystal displays.

**15.** Photoresist containing at least one photocurable monomer, at least one photo-initiator and at least one metal complex of an azo compound of the formula (I) according to Claim 1 which hosts at least one further compound.

**16.** Process for producing colour filters for liquid-crystal displays, **characterized in that** at least one metal complex of an azo compound of the formula I according to Claim 1 which hosts at least one further compound is ground in an organic solvent optionally in the presence of a binder resin and/or dispersant, and subsequently processed in the presence of photocurable monomers, photoreaction initiator and optionally further binder and/or solvent to form a photoresist which is thereafter applied by means of a suitable coating method, for example roller, spray, spin, dip or air knife coating, onto to a suitable substrate, generally a glass plate, irradiated by means of a photomask and then cured and developed to form the ready-produced coloured colour filter.

**17.** Colour filter containing at least one metal complex of an azo compound of formula (I) according to Claim 1 which hosts at least one further compound as guest.

**18.** Liquid-crystal display containing at least one colour filter according to Claim 17.

**19.** Use of metal complexes of azo compounds of the formula I according to Claim 1 which hosts at least one other compound as guest, in printing inks for producing colour filters by the method of photolithography, offset printing or mechanical, piezomechanical or thermal inkjet printing.

**20.** Use according to Claim 19, **characterized in that** the printing inks additionally contain an aqueous organic vehicle medium.

## Revendications

**1.** Utilisation de complexes métalliques d'un dérivé azoïque répondant à la formule (I) ou possédant l'une des structures tautomères

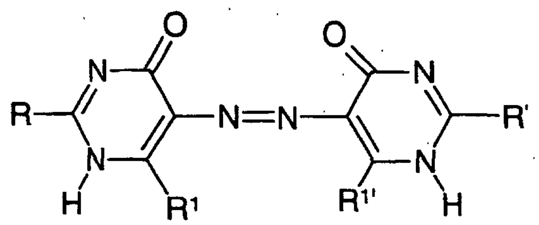

(I)

dans laquelle

R et R' représentent chacun, indépendamment l'un de l'autre, un groupe OH, $NH_2$, NH-CN, arylamino ou acylamino et

$R^1$ et $R^{1'}$ représentent chacun, indépendamment l'un de l'autre, un groupe -OH ou $-NH_2$,

et qui contient en occlusion au moins un composé, les complexes métalliques étant ceux des mono-, di-, tri- et tétra-anions des dérivés azoïques de formule (I) et des métaux Li, Cs, Mg, Cd, Co, Al, Cr, Sn, Pb, plus spécialement Na, K, Ca, Sr, Ba, Zn, Fe, Ni, Cu, Mn et La, en tant que pigments dans des filtres de couleur pour des affichages à cristaux liquides.

2. Utilisation selon la revendication 1, **caractérisée en ce que** le dérivé azoïque de formule (I) répond à la formule (II) ou a une forme tautomère

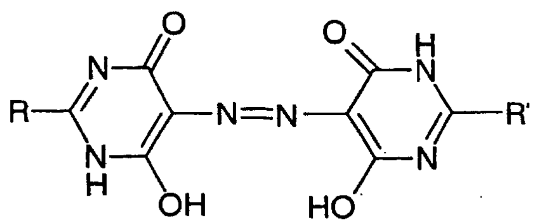

(II),

dans laquelle

R et R' représentent chacun, indépendamment l'un de l'autre, un groupe OH et NHCN.

3. Utilisation des complexes métalliques selon la revendication 1, **caractérisée en ce que** le composé occlus est un composé organique cyclique ou acyclique, et consiste plus spécialement en la mélamine ou un dérivé de mélamine ou un polycondensat, de préférence à base de l'urée et du formaldéhyde, ou un copolymère séquencé à base d'acide (poly)stéarique, d'oxyde de (poly)éthylène et/ou de (poly)propylène.

4. Utilisation des complexes métalliques selon la revendication 1, **caractérisée en ce que** ceux-ci consistent en complexes azo-métal 1:1 répondant à la formule (Ia) ou ayant une forme tautomère

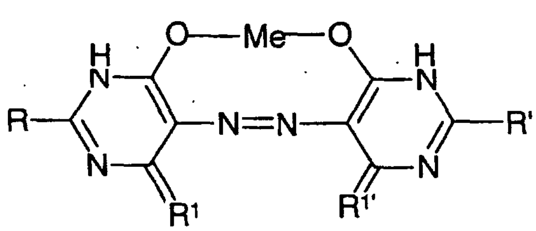

(Ia)

dans laquelle

| | |
|---|---|
| Me | désigne les métaux mentionnés dans la revendication 1, |
| R et R' et $R^1$ et $R^{1'}$ | ont les significations indiquées dans la revendication 1. |

**5.** Utilisation des complexes métalliques selon la revendication 1, **caractérisée en ce que** leur lieu de couleur est défini par les fractions de couleurs normalisées x et y suivantes :

$$x = 0{,}38 \text{ à } 0{,}72$$

$$y = 0{,}14 \text{ à } 0{,}55.$$

**6.** Utilisation de composés d'inclusion, de composés d'intercalation et de solutions solides selon la revendication 1, dans lesquels le complexe acide azobarbiturique-nickel 1:1 a l'une des formes tautomères de formule (IIa) et contient en occlusion au moins un autre composé de formule (III)

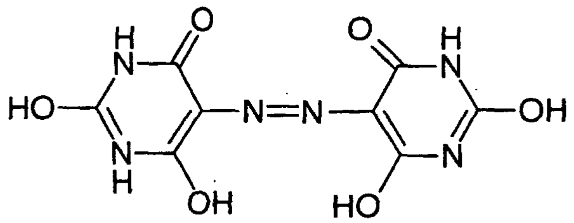

(IIa)

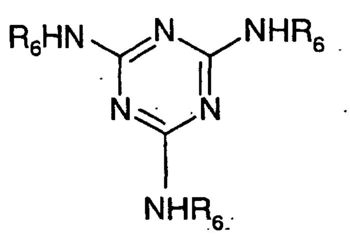

(III)

dans lesquelles

$R_6$ représente l'hydrogène ou un groupe alkyle en $C_1$-$C_4$, portant le cas échéant des substituants OH.

**7.** Utilisation selon la revendication 1, **caractérisée en ce que** le dérivé azoïque est un sel monopotassique ou dipotassique de formule (I, II, IIa, IIb, IIc) ou a l'une des structures tautomères, éventuellement à l'état d'hydrates.

**8.** Utilisation selon la revendication 1, **caractérisée en ce que** le dérivé azoïque est le sel monopotassique ou dipotassique de l'acide azobarbiturique de formule (IIa).

**9.** Compositions pigmentaires contenant

a) au moins un complexe métallique d'un dérivé azoïque répondant à la formule (I) ou ayant l'une des structures tautomères

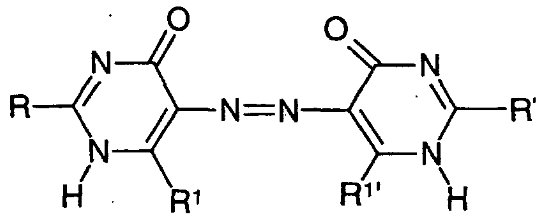

(I)

dans laquelle

R et R' représentent chacun, indépendamment l'un de l'autre, un groupe OH, $NH_2$, NH-CN, acylamino ou arylamino et

$R^1$ et $R^{1'}$ représentent chacun, indépendamment l'un de l'autre, un groupe -OH ou $-NH_2$,

les complexes métalliques contenant au moins un composé en occlusion, et consistant en les mono-, di-, tri- et tétra-anions des dérivés azoïques de formule (I) et de métaux choisis dans le groupe suivant : Li, Cs, Mg, Cd, Co, Al, Cr, Sn, Pb, de préférence Na, K, Ca, Sr, Ba, Zn, Fe, Ni, Cu, Mn et La,

b) au moins un composé organique choisi dans le groupe des terpènes, des terpénoïdes, des esters d'acides gras et du groupe des homo- ou co-polymères tels que les copolymères statistiques ou séquencés ayant dans l'eau à 20°C une solubilité < 1 g/l et plus spécialement < 0,1 g/l.

**10.** Composition pigmentaire selon revendication 9 contenant en outre de 1 à 100 % en poids, plus spécialement de 0,5 à 60 % en poids, par rapport au composé a), d'au moins un agent tensioactif répondant à la formule (X) ou (XI) :

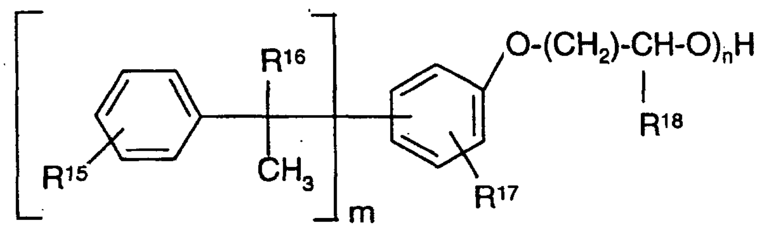

(X),

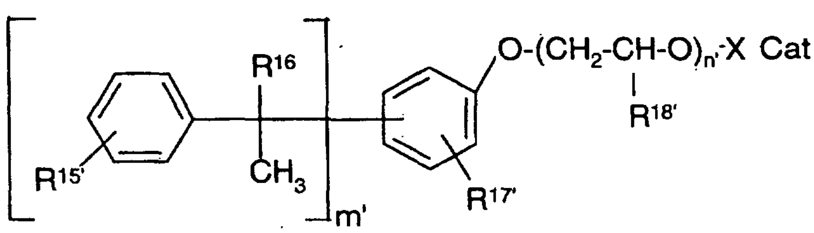

(XI)

dans lesquelles

$R^{15}$ représente l'hydrogène ou un groupe alkyle en $C_1$-$C_4$,

$R^{16}$ représente l'hydrogène ou un groupe $CH_3$,

$R^{17}$ représente l'hydrogène, un groupe alkyle en $C_1$-$C_4$, alcoxy en $C_1$-$C_4$, (alcoxy en $C_1$-$C_4$)carbonyle ou phényle,

m est un nombre allant de 1 à 4,

n est un nombre allant de 6 à 120,

$R^{18}$, ayant des significations identiques ou différentes pour chacun des motifs d'indice n, représente l'hydrogène, un groupe $CH_3$ ou phényle, et dans le cas où il y a présence simultanée de $CH_3$ dans les divers groupes $-(-CH_2$-CH

$(R^{18})$-O-)-, $R^{18}$ représente $CH_3$ pour 0 à 60 % de la valeur totale de n et l'hydrogène pour 100 à 40 % de la valeur totale de n, et dans les cas où il y a présence simultanée de groupes phényle dans les divers groupes -(-$CH_2$-CH $(R^{18})$-O-)-, il représente le groupe phényle pour 0 à 40 % de la valeur totale de n et l'hydrogène pour 100 à 60 % de la valeur totale de n,
et

$R^{15'}$, $R^{16'}$, $R^{17'}$, $R^{18'}$, m' et n' ont les significations indiquées respectivement pour $R^{15}$, $R^{16}$, $R^{17}$, $R^{18}$, m et n mais indépendamment de ceux-ci,

X représente un groupe $-SO_3$, $-SO_2$, $-PO_3$ ou -CO-$(R^{19})$-COO,

Cat représente un cation du groupe consistant en H, Li, Na, K, $NH_4$ ou HO-$CH_2CH_2$-$NH_3$, sous réserve que lorsque X = $-PO_3$, il y a deux Cat et

$R^{19}$ représente un radical aliphatique ou aromatique divalent, de préférence un groupe alkylène en $C_1$-$C_4$, plus spécialement éthylène; un radical mono-insaturé en $C_2$-$C_4$, spécialement acétylène, ou un groupe phénylène éventuellement substitué; en particulier ortho-phénylène, les substituants possibles consistant de préférence en groupes alkyle en $C_1$-$C_4$, alcoxy en $C_1$-$C_4$, (alcoxy en $C_1$-$C_4$)carbonyle ou phényle.

**11.** Compositions pigmentaires selon la revendication 9, **caractérisées en ce que** le dérivé azoïque de formule (I) répond à la formule (II) ou a une forme tautomère

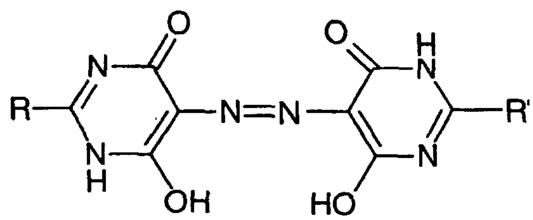

(II),

dans laquelle

R et R' représentent chacun, indépendamment l'un de l'autre, OH ou NHCN,

et le composé occlus consiste en un composé organique cyclique ou acyclique, plus spécialement en la mélamine ou un dérivé de mélamine ou en un polycondensat, de préférence à base d'urée et de formaldéhyde, ou en un copolymère séquencé à base d'acide (poly)stéarique, d'oxyde de (poly)éthylène et/ou d'oxyde de (poly)propylène.

**12.** Compositions pigmentaires selon la revendication 9, **caractérisées en ce que** les pigments (a) sont les complexes azométalliques 1:1 répondant à la formule (Ia) ou ayant une forme tautomère

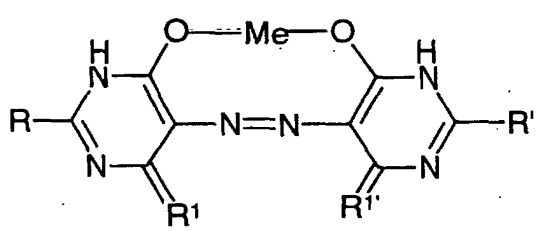

(Ia)

dans laquelle

Me représente les métaux mentionnés dans la revendication 1,

R et R' et $R^1$ et $R^{1'}$ ont les significations indiquées dans la revendication 1.

**13.** Compositions pigmentaires selon la revendication 9, **caractérisées en ce que** les pigments (a) sont des composés

d'inclusion, des composés d'intercalation et des solutions solides dans lesquels le complexe acide azobarbiturique-nickel, 1:1, a l'une des formes tautomères de formule (IIa) et contient au moins un autre composé de formule (III) en inclusion,

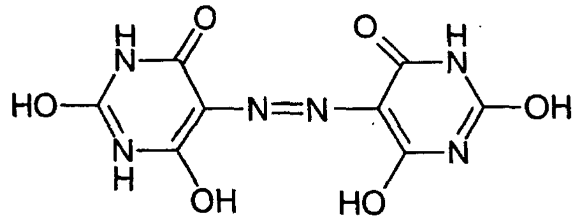

(IIa)

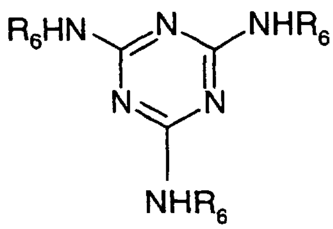

(III)

dans lesquelles

$R_6$ représente l'hydrogène ou un groupe alkyle en $C_1$-$C_4$, portant éventuellement des substituants OH.

**14.** Utilisation des compositions pigmentaires selon la revendication 9 pour la préparation de filtres de couleur pour affichages à cristaux liquides.

**15.** Vernis photographique contenant au moins un monomère photodurcissable, au moins un photo inducteur et au moins un complexe métallique d'un dérivé azoïque de formule (I) selon la revendication 1, qui contient en occlusion au moins un autre composé.

**16.** Procédé pour la préparation de filtres de couleur pour affichage à cristaux liquides, **caractérisé en ce que** l'on broie au moins un complexe métallique d'un dérivé azoïque de formule (I) selon la revendication 1, qui contient au moins un autre composé en occlusion, dans un solvant organique, le cas échéant en présence d'un liant résineux et/ou d'un agent dispersant puis on en forme, par addition de monomères photodurcissables, de photo-inducteurs et le cas échéant d'un autre liant et/ou solvant, un vernis photographique qui est ensuite appliqué, par des techniques de revêtement appropriées telles que le revêtement au rouleau, le revêtement par pulvérisation, le revêtement centrifuge, le revêtement par immersion ou le revêtement au couteau d'air, sur un support approprié, en général une glace, exposé à la lumière au travers d'un photomasque puis durci et développé en le filtre coloré fini.

**17.** Filtre de couleur contenant au moins un complexe métallique d'un dérivé azoïque de formule (I) selon la revendication 1, qui contient en occlusion au moins un autre composé.

**18.** Affichages à cristaux liquides contenant au moins un filtre de couleur selon la revendication 17.

**19.** Utilisation des complexes métalliques de dérivés azoïques de formule (I) selon la revendication 1, contenant en occlusion au moins un autre composé, dans des encres d'impression pour la préparation de filtres de couleur par la technique de photolithographie, d'impression en offset, ou d'impression mécanique, piézomécanique ou thermique par jet d'encre.

**20.** Utilisation selon la revendication 19, **caractérisée en ce que** les encres d'impression contiennent en outre un véhicule hydro-organique.